# EUROPEAN PATENT SPECIFICATION

(11) **EP 4 029 675 B1**
(45) Date of publication and mention of the grant of the patent: **29.05.2024**
(21) Application number: 21305063.6
(22) Date of filing: 19.01.2021
(51) Int. Cl.: B29C 64/124, B29C 64/135, G03F 7/00, B33Y 10/00, B33Y 70/00, G03F 7/027, G03F 7/40, G03F 7/32

(54) **3D-PRINTING METHODS AND SYSTEMS**
VERFAHREN UND SYSTEME ZUM 3D-DRUCKEN
PROCÉDÉS ET SYSTÈMES D'IMPRESSION 3D

(43) Date of publication of application: 20.07.2022
(73) Proprietor: Bostik SA, 92700 Colombes (FR)
(72) Inventor: GARRA, Patxi, 08193 Bellaterra, Barcelona (ES); CAMPOS BELLOSTAS, Laura, 08193 Bellaterra, Barcelona (ES); VICENÇ I ROMAGUERA, Mariona, 08193 Bellaterra, Barcelona (ES); FAGGI, Enrico, 08193 Bellaterra, Barcelona (ES)
(74) Representative: Bandpay & Greuter

(56) References cited:
- EP-A1- 0 963 420
- EP-A1- 1 056 757
- WO-A1-2017/021785

## Description

### TECHNICAL FIELD

The present invention belongs to the field of three-dimensional (3D) printing. It relates to methods for printing a three-dimensional article, to a system thereof, the use thereof, and to a 3D printed article manufactured therewith. The present invention relies on the use of liquid resins comprising cyanoacrylates.

### TECHNICAL BACKGROUND

Three-dimensional printing - also known as additive manufacturing processes - are methods of printing three-dimensional articles. These articles may be obtained from photosensitive powder, liquid or molten starting materials. Particularly, they may be obtained from resins such as monomers, being photopolymerizable at room temperature.

Different methods have been developed, including those based on the layer-by-layer approach.

The layer-by-layer approach can be implemented via a "top down" "point-by-point" serial processing method, e.g. fused deposition modeling, selective laser sintering, etc.

Alternatively, the layer-by-layer approach can be implemented via a "bottom-up" "slice-at-a-time" serial processing method, in which a layer of resin is photopolymerized using for example a digital light projector or a LCD mask combined with a light source, or by a stereolithographic method. A suitable device comprises at least a tank, a movable platform and a light source. The base of the tank comprises a bottom wall, which is optically transparent, hereby forming a window. The transparent window may be a durable transparent plastic film. The top surface of the transparent window, within the tank, may be a non-stick surface. The light source may be a digital light projector, a LED light source or any other suitable light source. When a LED light source is used, a mask may be interposed between the light source and the base of the tank. In this method, the light source is located below the tank, and emits light being transmitted through the transparent window. The platform comprises a bottom flat surface, facing the transparent window, and being generally positioned in a X-Y horizontal plane. The platform is movably mounted in the tank and may move up and down along a Z vertical axis.

A bath of liquid polymerizable resin is contained within the tank, and the platform is submerged in the liquid resin and moved downwards to the lowest position, at a specific distance between its bottom surface and the top surface of the transparent window. The zone - so-called "polymerization zone" - formed between both surfaces is filled with liquid resin. Upon exposure to light, the first solidified layer is formed in the polymerization zone and adheres to the bottom surface of the platform, while preferably not adhering to the top surface of the transparent window. Absent from any light, the build platform incrementally moves upwards, to create a new polymerization zone between the bottom surface of the solidified layer and the top surface of the transparent window, in which some liquid resin flows, for forming an additional layer of polymerized resin upon subsequent light exposure. The incremental move of the platform and the light exposure is repeated as often as necessary to obtain the solid three-dimensional article. If necessary, the platform may be moved incrementally further than the distance needed for forming a layer of polymerized resin, for ensuring that a sufficient and homogenous volume of resin flows to the polymerization zone, before being moved downwards again to the distance, which is suitable for forming a layer of polymerized resin.

The "slice-at-a-time" serial processing method allows obtaining satisfactory three-dimensional articles. However, this method is laborious and time-consuming, and has also several additional drawbacks. For example, cured layer stratification may be visible under powerful magnification, or even to the naked eye. The 3D article may exhibit some anisotropy in mechanical properties. The aesthetics may be compromised, particularly for the surfaces angled in the vertical Z axis. The 3D article may also have defects, particularly caused by the up and down movements of the platform.

Alternative methods, based on the principle of continuous 3D printing, have been developed, particularly for tackling the drawbacks associated with the up and down movements of the platform. Such methods may be continuous linear methods (continuous extraction methods) or continuous volumetric methods.

PCT application WO 2014/126834 A1 published on 21st August 2014 and the article entitled *"*Continuous liquid interface production of 3D objects" by from J. R. Tumbleston et al., Sciencexpress (2015) describe the method called "continuous liquid interface printing (CLIP)". In the CLIP method, the need for the repeated up and down movements of the platform is avoided and formed parts are "extracted" in a continuous way. The CLIP method is based on the continuous presence of unpolymerized liquid resin in the zone formed between the bottom surface of the platform/article and the top surface of the transparent window. This is achieved by balancing the inhibition and the initiation of the photopolymerization in this zone, via a decreasing gradient of an inhibitor of polymerization from the top surface of the transparent window to the bottom surface of the platform/article. This zone is therefore divided into two different zones that merge i.e. the polymerization zone per se and a so-called "dead zone" located in the vicinity of the top surface of the transparent window, wherein the inhibitor is present at a sufficient concentration for inhibiting the photopolymerization. At a threshold distance from the top surface of the transparent window, roughly demarcating the dead zone from the polymerization zone, the photopolymerization is no longer inhibited. The 3D article can be printed continuously, instead of step-by-step. PCT application WO 2014/126834 A1 describes alternative inhibition/photopolymerization systems *i*.*e*. one system wherein the liquid resin comprises a free radical polymerizable liquid resin with normal free radical stabilizers present for shelf-life and an additional inhibitor comprises oxygen (*e*.*g*. air, gas enriched in oxygen or pure oxygen gas), and another system wherein the liquid resin comprises an acid-catalyzed or cationically-polymerizable liquid resin and the inhibitor comprises a base (e.g. ammonia, trace amines or carbon dioxide). Additional inhibitor(s) may be provided to the bath of liquid resin through a window made of a material permeable to the inhibitors of polymerization, *e*.*g*. semipermeable fluoropolymers, rigid gas-permeable polymers, porous glass, or combinations thereof. J. R. Tumbleston *et al.* describes a method, wherein oxygen diffuses through the window and into the resin, but decays with distance from the window, so that photoinitiation overpowers oxygen-inhibition at some distance from the window. Hence, at the threshold distance, where inhibition including that by oxygen is consumed and initiating free radicals still exist, polymerization begins. This method allows the much faster manufacturing 3D articles showing no layer stratification and anisotropy in parts.

PCT application WO 2015/164234 A1 published on 29th October 2015 also describes an alternative CLIP method, wherein the tank is filed with two layers of liquids. The top layer comprises the liquid resin, and a bottom layer comprises an immiscible liquid, which is immiscible, but wettable with the resin and has a density greater than the resin. Inhibitors of polymerization *e*.*g*. oxygen, bases or organic compounds may also be used.

PCT application WO 2016/172784 A1 published on 3rd November 2016 describes the method called "Intelligent Liquid Interface (ILI)". The ILI method does not rely on the provision of inhibitors of polymerization. Instead, the top surface of the optically transparent bottom wall of the tank is coated with a wettable material *e*.*g*. a silicone hydrogel. A dead zone is formed atop the wettable material, as a result of the intermolecular forces of repulsion between the wettable material and the resin, or as a result of the formation of a layer of water (present in the wettable material), in which the resin is immiscible. The US application 2018/0207867 A1 published on 26th July 2018 describes a method, wherein the optically transparent portion is covered by a layer gradually releasing a liquid lubricant. The US application 2017/0129175 A1 published on 11th May 2017 describes an ILI method, wherein the wettable membranes are movable and not static.

PCT application WO 2018/208378 published on 15th November 2018, the article entitled *"*Volumetric 3D printing of elastomers by tomographic backprojection" by D. Loterie (2018) and the article entitled *"*Volumetric additive manufacturing via tomographic reconstruction" by B. E. Kelly et al., Science (2019) describe the method called "Computed Axial Lithography (CAL)", based on a volumetric continuous printing. In the CAL method, a standard resin is contained within a rotatable, optically transparent tank. It may comprise free radical polymerizable liquid resin and radical stabilizers including oxygen, which act as inhibitors of photopolymerization. Any and all stabilizers are already present in the resin and are not continuously supplied. Light projections from the side of the tank are simultaneously directed at a plurality of angles. The superposition of exposures from different angles results in a 3D energy dose which is sufficient to photopolymerize the resin in the desired geometry.

The article entitled *"*Two-color single-photon photoinitiation and photoinhibition for subdiffraction photolithography" by T. F. Scott et al., Science (2009), US application 2012/0092632 A1 published on 19th April 2012 and the article entitled *"*Rapid, continuous additive manufacturing by volumetric polymerization inhibition patterning" by M. P. de Beer et al., Science Advances (2019) describe a dual-wavelength volumetric photopolymerization method. In this method, one wavelength is used to photochemically activate the polymerization, while a second wavelength is used to inhibit that reaction. M. P. de Beer *et al.* also discloses hexaarylbiimidazoles as radical polymerization photoinhibitors, even though the concept of "photoinhibition" is relatively rare.

Continuous 3D printing methods are advantageous over methods based on the layer-by-layer approach, particularly due to their speed of article formation and the quality of the printed parts. Many of these methods rely on the use of inhibitors of photopolymerization, particularly inhibitors for free radical polymerizable liquid resin, such as oxygen or air. Indeed, irrespective of the types of polymerizable liquid resins used for example in CLIP methods - including polyurethane, epoxy, cyanate ester, and silicone resins - all depend on oxygen inhibited acrylic cures. No alternative resin systems have been demonstrated. However, the use of such liquid resins is associated with several drawbacks. Firstly, the need to finely tune the sensitivity of these liquid resins to radical photopolymerization in the action of continuous printing, in turn creates stability issues with product storage and usually requires packaging and selling these as two-part formulations that are mixed before use. Secondly, these liquid resins should be further finely tuned to function when balancing inhibition by controlling the diffusion of supplied oxygen. Thirdly, the oxygen diffusion varies as a function of the resin viscosity, and therefore needs to be adjusted depending on resin type and its pot life. Fourthly, costly specialized membranes with high permeability to air/oxygen and transparency are required to form the optically transparent portion.

Different liquid resins are conventionally used in 3D printing methods. For example, in theory, the liquid resins may comprise polymerizable monomers selected from the group consisting of acrylics, methacrylics, acrylamides, styrenics, olefins, halogenated olefins, cyclic alkenes, maleic anhydride, alkenes, alkynes, carbon monoxide, functionalized oligomers, multifunctional cure site monomers, functionalized PEGs, and combinations thereof. See for example WO 2015/164234 A1, WO 2015/164234 A1, and the article by D. Loterie (2018). However, in practice, the vast majority of photopolymerized 3D articles are obtained from free radical polymerizable monomers, particularly from (meth)acrylates and their derivatives, which are commonly inhibited by oxygen or air, as disclosed in the article entitled *"*Role of Oxygen in polymerization reactions" by V. A. Bhanu et al., Chemical Reviews (vol. 91, No. 2, 1991). Controlling inhibition by oxygen or air can be used advantageously to create polymerization dead zones during 3D printing, for example in conventional CLIP method. However, oxygen inhibition also is disadvantageous in that printing with (meth)acrylated resins provides articles whose surfaces are in contact with ambient air (oxygen) and thus remain partially uncured and tacky. In order to obtain a tack-free surface, the 3D printed article should thus be post-processed (see e.g. in WO 2019/043529 A1). The post-processing to complete cure of the 3D printed articles may require additional hardware and currently is a time-consuming process that may also involve heating. To be specific, 3D printing methods have limitations in terms of absorptivity of the liquid resin and the overall time of printing, mainly caused by the materials and formulations used. For example, while CLIP and CAL methods may be set up to print a 3D article within minutes or even seconds, the 3D articles obtained from liquid resins comprising conventional (meth)acrylate monomers remain partially uncured and have tacky surfaces. They thus need to be post-processed. However, the post-processing step usually requires many minutes, if not hours, to be completed for obtaining a non-tacky 3D article. In known techniques, some degree of post-processing is always required, in order to improve the chemical, physical and mechanical properties of the 3D articles and also its aesthetics. Post-processing may include removing supports on which the 3D article grows, removing excess polymerized materials, washing, post-curing, sanding or polishing, painting or colouring. Post-processing steps in known techniques significantly increase the cost for producing 3D printed articles.

WO2017/021785A1 discloses a photolithographic method using a cyanoacrylate-based resin and a ferrocene initiator to promote anionic polymerisation.

3D articles obtained from known techniques, particularly using conventional (meth)acrylate monomers, are usually made from crosslinked resins, which have no possibility to being partly or completely dissolved, if desired. However, such dissolution may be of interest for example for recycling or removing the printed supports. The importance of recycling 3D articles has been highlighted in the article entitled *"*Sustainable photopolymers in 3D printing: a review on biobased, biodegradable, and recyclable alternatives" by Voet et al., Macromol. Rapid Commun. (2020).

There is thus a need for optimizing the benefits of all 3D printing methods, particularly continuous 3D printing methods, being independent from inhibition by oxygen or air. There is also the need for providing a 3D printing method enabling the printing of 3D articles having no surface-tackiness, whether used in the continuous extraction approach *e*.*g*. the CLIP method, or in the volumetric approach or in layer-by-layer approach. There is also the need for providing a 3D printing method, wherein post-processing steps are optimized. There is also the need for providing a method to print and process objects, wherein the time to effect post-processing steps, particularly those directed at achieving dry parts with tack-free surfaces, is significantly reduced *versus* known techniques, particularly using conventional (meth)acrylate monomers. There is also the need to supply shelf-stable one-part liquid resin systems with long lifetime storage. There is also the need for providing a 3D printing method that can exploit relatively simple equipment without the need for special hardware *e*.*g*. to provide or transport gases. There is also the need to provide 3D printing methods enabling the printing of 3D articles with useful physical, mechanical, and chemical properties in terms of durability and recyclability. There is also the need for providing 3D articles that can be recyclable.

### SUMMARY OF THE INVENTION

It is a first object of the invention to provide a method for printing a three-dimensional (3D) article, comprising the steps of:
a) providing a volume of liquid resin comprising cyanoacrylate-based monomers, a photoinitiator system promoting anionic or zwitterionic polymerization and an acidic inhibitor, held in a tank, said tank comprising at least one optically transparent portion;
b) defining a polymerization zone;
c) emitting and controlling light and transmitting it to the liquid resin through the optically transparent portion for selectively polymerizing the liquid resin in the polymerization zone;
d) obtaining a three-dimensional article made of a polymerized resin;
e) treating the obtained three-dimensional article with a non-nucleophilic rinsing solvent for removing the excess liquid resin; and,
f) optionally exposing the obtained three-dimensional article with an additional light source for rendering the article non-tacky.

In some embodiments, the method is a layer-by-layer 3D printing method or a continuous 3D printing method; preferably a continuous 3D printing method being a continuous linear (extraction) 3D printing method or a continuous volumetric 3D printing method; more preferably the method is selected from the group consisting of the continuous liquid interface printing method (CLIP method), the intelligent liquid interface method (ILI method), the computed axial lithography method (CAL method), the dual-wavelength volumetric photopolymerization method, and the methods derived therefrom. In a one embodiment, the method is the computed axial lithography method (CAL method). In an alternative embodiment, the method is the continuous liquid interface printing method (CLIP method).

In some embodiments, the cyanoacrylate-based monomers are selected from the group consisting of mono-functional cyanoacrylate monomers, multi-functional cyanoacrylate monomers including bifunctional cyanoacrylate monomers, hybrid cyanoacrylate monomers, and mixtures thereof.

In some embodiments, the cyanoacrylate-based monomers are exclusively mono-functional cyanoacrylate monomers.

In some embodiments, the cyanoacrylate-based monomers are multi-functional cyanoacrylate monomers, hybrid cyanoacrylate monomers and mixtures thereof and optionally mono-functional monomers. Multi-functional cyanoacrylate monomers are in particular bifunctional cyanoacrylate monomers. Hybrid-functional cyanoacrylate monomers comprise cyanoacrylate together with (meth)acrylic functional groups.

In some embodiments, the cyanoacrylate-based monomers are selected from 2-methoxyethyl cyanoacrylate, methyl cyanoacrylate, ethyl cyanoacrylate, n-propyl cyanoacrylate, iso-propyl cyanoacrylate or mixtures thereof; preferably from 2-methoxyethyl cyanoacrylate, methyl cyanoacrylate or mixtures thereof.

In some embodiments, the acidic inhibitor present in the liquid resin is selected from Lewis acids, Bronsted acids or mixtures thereof; preferably from Lewis acids; more preferably from the group consisting of boron trifluoride and derivatives, fluoroboric acid, sulphur dioxide, and mixtures thereof; still more preferably from the group consisting of boron trifluoride, boron trifluoride etherate complex, boron trifluoride dihydrate complex, boron trifluoride tetrahydrofuran complex, trimethylsilyl triflate, sulphur dioxide, and mixtures thereof; most preferably the Lewis acid is etherate complex.

In some embodiments, the method further comprises the step of providing an additional source of acidic inhibitors; preferably an additional source of acidic inhibitors selected from the group consisting of Lewis acids, Bronsted acids, acids provided from an acidic ion exchange material or *in situ* photogenerated acids.

In some embodiments, the additional acidic inhibitors diffuse to the volume of liquid resin from/through the optically transparent portion.

In some embodiments, the additional acidic inhibitors diffuse to the volume of liquid resin from a separate compartment.

In some embodiments, the additional acidic inhibitors are in contact with the volume of liquid resin from a liquid or wettable, optically transparent material overlying the inner surface of the optically transparent portion of the tank.

In some embodiments, it is provided a resin-immiscible liquid, also held in the tank, wherein the additional acidic inhibitors are in contact with the liquid resin at the interface with the resin-immiscible liquid.

In some embodiments, an additional light, of a different wavelength than the light selectively polymerizing the liquid resin, is emitted and transmitted to the liquid resin, and additional acidic inhibitors are generated in the volume of liquid resin by additional light. The additional acidic inhibitors are thus latent until photogenerated *in situ* in the volume of liquid resin.

In some embodiments, the liquid resin comprises, as the photoinitiator system, a combination of metallocene compounds and radical photoinitiators.

In some embodiments, the liquid resin comprises additional photopolymerizable monomers, preferably (meth)acrylate monomers.

In some embodiments, the non-nucleophilic rinsing solvent is selected from the group consisting of hydrocarbon and perfluorinated hydrocarbon solvents, ether solvents, acetate solvents, chlorohydrocarbon solvents, polar aprotic solvents, and mixtures thereof.

In some embodiments, the step of treating the three-dimensional article with a non-nucleophilic rinsing solvent is carried out during a period of 10 minutes or less, preferably of 4 minutes or less, more preferably of 3 minutes or less.

In some embodiments, the step of treating the 3D article with a non-nucleophilic rinsing solvent is carried out by dipping the 3D article into the non-nucleophilic rinsing solvent for a period of 15 seconds or less.

In some embodiments, the step of exposing the three-dimensional article to an additional light source is carried out at a wavelength from 380 nm to 470 nm.

In some embodiments, the step of exposing the three-dimensional article to an additional light source is carried out for a period of 60 seconds or less, preferably from 1 to 30 seconds, more preferably from 1 to 20 seconds.

An embodiment not currently claimed provides a three-dimensional printing system comprising:
a) a volume of liquid resin comprising cyanoacrylate-based monomers, a photoinitiator system and an acidic inhibitor, said volume comprising a polymerization zone;
b) a tank for holding the volume of liquid resin, said tank comprising at least one optically transparent portion;
c) a light source emitting light for selectively polymerizing the liquid resin in the polymerization zone; and
d) a source of non-nucleophilic rinsing source.

Another embodiment not currently claimed provides the use of a liquid resin comprising cyanoacrylate-based monomers, a photoinitiator system and an acidic inhibitor in a system for printing three-dimensional articles.

A further embodiment not currently claimed provides a three-dimensional printed article obtained by the method as described herein.

Yet another embodiment not currently claimed provides a three-dimensional printed article made of polycyanoacrylate, preferably an unstratified, tack-free three-dimensional printed article made of polycyanoacrylate.

Yet another embodiment not currently claimed provides a method for recycling a 3D article made of polycyanoacrylate, obtained exclusively from mono-functional cyanoacrylate monomers, comprising the step of treating the three-dimensional article with a dissolving solvent for a time sufficient for dissolving it.

In some embodiments, not currently claimed, the step of treating the three-dimensional article with a dissolving solvent is carried out during a period of 60 minutes or more, preferably from 1 to 72 hours, more preferably from 2 to 48 hours.

The present invention makes it possible to overcome the drawbacks of the prior art. The invention provides a 3D printing method, particularly a continuous 3D printing method, being independent from inhibition by oxygen or air, and not relying on radical photopolymerization as the principle method of initiation, contrary to conventional liquid resins. The invention also provides a 3D printing method using a liquid resin being easily stored and being stable over time, i.e. not needing any specific packing conditions such as multicompartment formulations and/or having a limited shelf-life due to instability. The invention also provides a 3D printing method enabling the printing of 3D articles that do not exhibit stratification. The invention also provides a 3D printing method enabling the printing of 3D articles having no surface-tackiness whether used in continuous linear approach or in volumetric approach or layer-by-layer approach. The invention also provides a 3D printing method that can exploit relatively simple equipment without the need for special hardware e.g. to provide or transport gases or complex peripheral hardware to post-process 3D printed articles having tacky surfaces due to air inhibition. The invention also provides a 3D printing method enabling obtaining 3D articles of improved quality, while relying on conventional physical and optical settings. The invention also provides a 3D printing method enabling the printing of 3D articles with improved physical, mechanical, and chemical properties in terms of durability. The invention also provides a 3D printing method with an optimized postprocessing, thereby enabling significantly reducing the time needed for postprocessing the 3D articles. The invention also provides a 3D printing method which has an improved productivity. In another aspect, the invention provides a method for recycling, at least in part, 3D articles.

The inventors have shown that liquid resins comprising cyanoacrylate-based monomers are uniquely adaptable to 3D printing methods, in a variety of modes and that the physical properties of the printed 3D objects can be readily modified. Indeed, 3D printed articles of improved quality, particularly not exhibiting layer stratification and/or not having surface-tackiness, can be obtained with conventional 3D printing systems using liquid resins comprising cyanoacrylate-based monomers, without requiring any specific adaptation of their physical and optical settings. The inventors have also shown that the physical, mechanical, and chemical properties in terms of durability and recyclability of the 3D articles could be adapted by choosing suitable cyanoacrylate-based monomers and by implementing a posttreatment step after obtaining the 3D article.

### DESCRIPTION OF THE FIGURES

Figure 1 is a photograph of a reference 3D article having the shape of the "3Dbenchy" calibration boat.
Figure 2 is a photograph of a 3D article having the logo ARKEMA according to example 5.

### DESCRIPTION OF EMBODIMENTS

The invention will now be described in more detail without limitation in the following description.

Throughout the description, all the percentages of the various constituents of the composition are given by weight (%w/w), except if mentioned otherwise. The concentration ranges have to be considered as including the limits.

The expressions "printing method (method for printing)" and "manufacturing method (method for manufacturing)" are used interchangeably presently. Likewise, the expressions "printing system" and "manufacturing system" are used interchangeably presently.

The present invention relates to a method for printing a three-dimensional article and the corresponding three-dimensional printing system and use thereof, as well as related 3D articles.

### 3D printing method

The present invention can be applied to any suitable conventional 3D printing methods using a photopolymerizable liquid resin, particularly without requiring any specific adaptation of their physical and optical settings.

The inventors have demonstrated the great versatility of using a liquid resin comprising cyanoacrylate-based monomers, photoinitiators and acidic inhibitors. Indeed, a liquid resin comprising cyanoacrylate-based monomers can be used in conventional 3D printing systems with or without simple modifications. In addition, the acidic inhibitors can be supplied in any form and manner. The suitable acidic inhibitors, and their supplies, may therefore be selected depending on the 3D printing method used. Particularly, the acidic inhibitors may be present originally in the liquid resin *i*.*e*. as the sole or a primary source of acidic inhibitors. In addition, a secondary source of acidic inhibitors may also be provided.

The 3D printing method may be a layer-by-layer 3D printing method. Alternatively and preferably, the 3D printing method may be a continuous 3D printing method, particularly a continuous linear 3D printing method or a continuous volumetric 3D printing method. Without wishing to be exhaustive, the continuous 3D printing method may be selected from the group consisting of the continuous liquid interface printing method (CLIP method), the intelligent liquid interface method (ILI method), the computed axial lithography method (CAL method), the dual-wavelength volumetric photopolymerization method, and the methods derived therefrom. The CAL method and the dual-wavelength volumetric photopolymerization method are referred presently as "volumetric printing methods", except mentioned otherwise. In one embodiment, the method is the computed axial lithography method (CAL method). In another embodiment, the method is the continuous liquid interface printing method (CLIP method). These methods and their suitable physical and optical settings are known in the art.

The 3D printing method may be implemented by the printing system described herein. The 3D printing method allows the printing of 3D articles made of polycyanoacrylate.

### Printing system

Existing printing methods can be used with the present invention without limitation particularly, since acid inhibitors stabilize cyanoacrylate-based monomers effectively outside the polymerization zone, while light is transmitted to the liquid resin to selectively polymerize such resins within the polymerization zone. Indeed, the acidic inhibitor(s) generally keeps(-) concurrently preventing the polymerization of the cyanoacrylate-based monomers outside the polymerization zone, when light is transmitted to the liquid resin for selectively polymerizing it.

### Tank

A tank is provided. The tank comprises at least one compartment for holding the liquid resin. The tank usually comprises a bottom wall and at least one side wall. The tank may open or closed at its top. The tank may have any suitable shape, cross-section and dimensions. For example, the bottom wall may have a cross-section being circular, square or rectangular. If the cross-section of the bottom wall is circular, the tank may have one circumferential cylindrical side wall. If the cross-section of the bottom wall is square or rectangular, the tank may have four side walls. In continuous linear 3D printing methods such as in CLIP and ILI methods, the tank preferably has a square or rectangular cross-section. In volumetric 3D printing methods, the tank preferably has a circular cross-section and forms a cylinder.

The tank may be fixed or rotatably moveable. In continuous linear 3D printing methods such as in CLIP and ILI methods, the tank is preferably fixed. In the volumetric 3D printing CAL method, the tank is preferably rotatably moveable around a vertical Z axis.

### Optically transparent portion

The tank comprises at least one optically transparent portion. The optically transparent portion may be located on the bottom wall, on the side walls, or both. In continuous linear 3D printing methods such as in CLIP and ILI methods, the optically transparent portion is preferably located on the bottom wall of the tank, and maybe planar. In volumetric 3D printing methods, the optically transparent portion is preferably located on the side wall of the tank.

Depending on the method, the inner surface of the optically transparent portion, in contact with the liquid resin, may be treated for preventing adhesion of the polymerized resin on it. For example, in a CLIP method, a fluorinated coating in the form of a transparent impermeable plastic sheet may be applied. Alternatively, as described in the US application 2017/0028618 A1, high-density, immiscible perfluorinated liquids may be disposed atop the inner surface of the optically transparent portion. Perfluorinated liquids may be perfluorinated sulfonic acids (also known as perfluorinated octanesulfonic acid or PFOS).

The material forming the optically transparent portion may be selected depending on the properties expected. For example, in a CLIP method, the optically transparent portion may be made in a material being permeable to the acidic inhibitors. In the CAL method, permeability and membranes are not required.

### Partition wall

In CLIP methods, the tank may comprise a partition wall, for dividing the tank into two compartments *i*.*e*. a top compartment and a bottom compartment. The top compartment may hold the liquid resin, while the bottom compartment may hold another liquid *e*.*g*. an additional source of acidic inhibitors such as a solution of acidic inhibitor.

The partition wall may be nonpermeable to the liquid resin, but permeable to acidic inhibitors. The partition wall may also comprise at least one optically transparent portion.

### Liquid or wettable, optically transparent material

In CLIP methods, the tank may comprise a liquid or wettable, optically transparent material, such as a membrane overlying the inner surface of the optically transparent portion of the tank.

This material may comprise acidic inhibitors derived from acids or acid groups. It may alternatively be continuously fed by a source of acid.

### Light source

A light source is provided. The light source emits light from one or a plurality of elements.

The light source is located outside the tank, in a position suitable for allowing the transmission of the light to the volume of liquid resin, particularly the photopolymerization zone, through the optically transparent portion.

The light may be continuously emitted and transmitted, for continuously photopolymerizing the liquid resin.

In continuous 3D printing methods such as in CLIP, ILI and volumetric printing methods, the light is usually emitted and transmitted continuously. In the course of the printing, the light may be controlled for customizing the shape of the 3D article.

In continuous linear 3D printing methods such as CLIP and ILI methods, the light source is located below the tank, and the light is emitted and transmitted through the optically transparent portion located in the bottom wall of the tank. If the tank comprises a bottom compartment and a top compartment, the light is also emitted and transmitted through the optically transparent partition wall.

In the volumetric 3D printing methods, the light source(s) may be located, to one side of the tank.

The light source emits light for polymerizing the liquid resin (polymerization light). The polymerization light may have a wavelength from 360 nm to 465 nm, preferably from 385 nm to 420 nm, more preferably from 405 nm to 415 nm.

In some special case printing methods, the light source may emit additional light for photoinhibiting the polymerization (inhibiting light). The additional light has different wavelength than the light for polymerizing the liquid. The photoinhibition light may have a wavelength from 300 nm to 500 nm, preferably from 350 nm to 450 nm, more preferably from 360 nm to 410 nm. The wavelength of the polymerization light and the wavelength of the additional light, which are different from each other, depend on the liquid resin and the type of polymerizable monomers. In these printing methods, even though photoinitiating and photoinhibiting wavelength ranges may be similar, it is understood that the selected wavelengths for initiating and inhibiting must not interfere or be the same.

### Light-controlling device

A light-controlling device is usually provided. This device may be part of the light source or independent to it. For example, the light-controlling device may be a digital light projector, a LCD mask, a shutter or a scanned laser.

When independent from the light source such as the mask or the shutter, the light-controlling device is interposed between the light source and the external surface of the optically transparent portion. The mask and the shutter may be useful for giving a specific pattern and/or intensity to the light, in order to photopolymerize the resin in a specific shape. Alternatively, in CLIP methods only, the light pattern may be created directly by the so-called stereolithographic approach (SLA). In CAL methods, the light-controlling device may project patterns sideways-on to the formulation from a plurality of angles, as it is rotated in a transparent cylindrical tank (vat) around a symmetrical vertical axis.

The use of a light-controlling device helps obtaining 3D articles having more or less complex shapes.

### Platform

Depending on the printing method, a platform may be provided. When a platform is present, it is usually moveably mounted on an arm, for allowing moving the platform up and down.

Usually, continuous 3D printing methods such as CLIP and ILI methods comprise a platform, particularly a planar platform, which is submerged in the liquid resin. The first layer of photopolymerized resin is formed on and adheres to the bottom surface of the platform, which is facing the top surface of the optically transparent portion.

Volumetric printing methods generally do not utilize a platform but print 3D articles in the volume of the liquid resin that are self-supporting or may be printed atop or around an inserted substrate.

### Liquid resin

A volume of a liquid resin is provided. The volume of liquid resin is held in the tank.

The liquid resin is held in the compartment formed by tank. If a partition wall is present, the liquid resin is held in the top compartment of the tank.

The liquid resin comprises cyanoacrylate-based monomers.

The volume of the liquid resin comprises a polymerization zone. By "polymerization zone" is meant a specific zone of the volume of the liquid resin, where the polymerization happens when the necessary conditions of exposure to induce photopolymerization are met. The polymerization zone may vary depending on the printing method used. For example, in the CLIP method, the polymerization zone is particularly demarcated by the bottom surface of the platform/article and the top surface of the optically transparent portion of the tank. In the CAL method, the polymerization zone is demarcated by the pattern formed by the light. The polymerization zone thus depends on the conventional physical and optical settings of the 3D systems.

The volume of the liquid resin may also comprise a dead zone. By "dead zone" is meant a specific zone in the vicinity of the polymerization zone, where the polymerization does not happen, even when the necessary conditions of exposure to induce photopolymerization are met. The dead zone is particularly present in continuous linear methods *e*.*g*. in the CLIP method. The dead zone is located in the vicinity of the bottom of the compartment holding the liquid resin (*i*.*e*. the top surface of the transparent window, the partition wall, the liquid or wettable material or any other means). In this embodiment, the dead zone is sandwiched between the bottom of the compartment holding the liquid resin and the polymerization zone. The dead zone may be obtained by the presence of acidic inhibitors including the secondary source of acidic inhibitors at a sufficient concentration for inhibiting the photopolymerization. Hence, the concentration of acidic inhibitors decreases with distance above the bottom of the compartment holding the liquid resin, so that a threshold is reached whereby photoinitiation purposely overpowers the acidic inhibition at some distance between the dead zone and the polymerization zone.

The liquid resin has a suitable viscosity. Particularly, the liquid resin may have a viscosity from 2 mPa.s to 100,000 mPa.s. In continuous 3D printing methods such as such as CLIP and ILI methods, the liquid resin may have a viscosity from 10 mPa.s to less than 10,000 mPa.s, preferably from 10 mPa.s to 2,000 mPa.s; or alternatively gel-like viscosities may also be deployed with viscosities from 10,000 cPs to 100,000 cPs. In volumetric 3D printing methods, the liquid resin preferably has a viscosity from 30 cPs to 100,000 cPs. Viscosity is measured using a Brookfield DV2T Viscometer with a thermostatic chamber equilibrated at 25°C. The spindles and shear rate are chosen to suit viscosity ranges, thus 1.5 r.p.m using spindle 14 for high viscosity range and 50 r.p.m. using spindle 21 for low viscosity range.

The liquid resin may be at a temperature from 20°C to 70°C.

In some embodiment, the liquid resin is at room temperature. By "room temperature" is meant a temperature from 18 °C and 25 °C.

In some embodiments, the liquid resin is at temperature higher than the room temperature, such as a temperature from 35°C to 75°C. In such case, a heating device is provided.

### Cyanoacrylate-based monomers

The liquid resin comprises cyanoacrylate-based monomers, which are photopolymerizable monomers. Cyanoacrylate (CA) is the generic name given to a family of alpha-nitrile substituted acrylic esters that are rapidly polymerisable. The terms "cyanoacrylate(s)", "cyanoacrylate monomers" and "cyanoacrylate-based monomer(s)" are used interchangeably presently.

Cyanoacrylate-based monomers are particularly suitable for an anionic or a zwitterionic polymerization. The mechanism of anionic polymerization is described in the article by Pepper et al., J. Polym. Sci: Polymer Symposium 62, 65-77 (1978) and the article entitled *"*Zwitterionic polymerization of butyl cyanoacrylate by triphenylphosphine and pyridine" by Cronin et al., Makromol. Chem., 189, 85, (1988). To be specific, the mechanism of the photopolymerization of cyanoacrylate monomers is initiated by electron-rich species that have been photogenerated.

The inventors have surprisingly demonstrated that satisfactory printing methods may be developed, using liquid resins different from conventional liquid resins i.e. liquid resins comprising (meth)acrylate monomers or other similar monomers. Indeed, the photopolymerization of (meth)acrylate monomers is based on free radical polymerization. However, free radical polymerization is inhibited by oxygen (air). Even though the oxygen inhibition of free radical photopolymerization has been used in some printing methods such the CLIP method, it has drawbacks. Particularly, the printed 3D articles usually show surface-tackiness, therefore requiring post-processing to render them dry-to-touch. In contrast, by using cyanoacrylate-based monomers, the inventors have demonstrated that 3D articles being tack-free, or having at least a limited surface-tackiness, could be printed, without impairing the efficacy of the photopolymerization. The inventors have also demonstrated no layering (stratification) phenomena occurs, when using liquid resin comprising cyanoacrylate-based monomers, especially in 3D printing methods based on the layer-by-layer approach. Additionally, liquid resins comprising cyanoacrylate-based monomers are stable upon time, particularly since they comprise acidic inhibitors, and do not require any special storage conditions, except shielding from light as with photocurable resins of any type.

Cyanoacrylate-based monomers may be mono-functional cyanoacrylate monomers, multi-functional cyanoacrylate monomers including bifunctional cyanoacrylate monomers, hybrid cyanoacrylate monomers, and mixtures thereof. Hybrid cyanoacrylate monomers are cyanoacrylate-based monomers comprising at least one additional moiety other than a cyanoacrylate moiety, preferably with the capacity to polymerize or react from the additional moiety e.g. monomers comprising a cyanoacrylate moiety and a (meth)acrylate moiety, or monomers comprising a cyanoacrylate moiety and a isocyanate moiety. Using multi-functional cyanoacrylate monomers and/or hybrid cyanoacrylate monomers, in addition to or instead of mono-functional cyanoacrylate monomers, may help obtaining polymers with improved properties through secondary reactions such as crosslinking, condensations and/or copolymerization that contribute to durability, toughness, flexibility, etc.

In one embodiment, the cyanoacrylate-based monomers are exclusively mono-functional cyanoacrylate monomers. The 3D articles obtained in such cases are made of non-thermosetting polymers.

In another embodiment, the cyanoacrylate-based monomers are multi-functional cyanoacrylate monomers, hybrid-functionalised cyanoacrylate monomers, or mixtures thereof and optionally mono-functional cyanoacrylate monomers. Multi-functional monomers are in particular bifunctional cyanoacrylate monomers. Hybrid-functional monomers comprise cyanoacrylate together with (meth)acrylic functional groups. The 3D articles obtained in such cases are made of thermosetting polymers.

The inventors have shown that the physical, chemical and mechanical properties of the 3D articles may vary depending on the type of cyanoacrylate-based monomers used *i.e.* mono-functional *versus* multi-functional cyanoacrylate monomers and hybrid monomers, allowing obtaining 3D articles having different durability profiles. Such versatility is advantageous.

The cyanoacrylate-based monomers may be selected depending on the 3D article to be printed, considering their specific properties including their solubility or insolubility, their toughness, their flexibility, their rigidness, their resistance, etc.

Monofunctional cyanoacrylate monomers have the chemical formula (I): 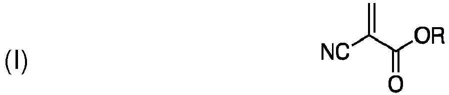 wherein R may be selected from the group consisting of an alkyl group or an alkoxyalkyl group. The alkyl group may be selected from the group consisting of methyl, ethyl, butyl, or 2-octyl. The alkoxyalkyl group may be selected from the group consisting of 2-methoxyethyl, 2-ethoxyethyl, or 2-(1-methoxy)propyl.

An exemplary monofunctional cyanoacrylate monomer is ethyl cyanoacrylate (ECA), wherein R = C₂H₅. While being suitable for use in the present invention, ECA is least preferred in view of its volatility, its odor and its staining potential. In some embodiments, the liquid resin is free of ethyl cyanoacrylate.

Other exemplary monofunctional cyanoacrylate monomers are 2-methoxyethyl cyanoacrylate (MECA), wherein R = CH₂CH₂OCH₃; 2-ethoxyethyl cyanoacrylate (EECA), wherein R = CH₂CH₂OC₂H₅; and 2-(1-methoxy)propyl cyanoacrylate (MPCA), wherein R = CH(CH₃)CH₂OCH₃. MECA is particularly suitable for use in the present invention, considering its odorless, non-lachrymatory, non-irritant and non-staining properties. A high-yield process for preparing MECA and related cyanoacrylates is disclosed in the US application 9,670,145 published on 26th January 2017.

Monofunctional cyanoacrylate monomers are well known in the art. See for example the review entitled *"*Adhesives Technology Handbook' by from S. Ebnesajjad Ed., William Andrew, Norwich (2008).

Monofunctional cyanoacrylate monomers are particularly suitable for obtaining 3D articles that are potentially recyclable i.e. 3D articles that may be dissolved, under suitable conditions, in some dissolving solvents, at least in part, after obtaining them.

Multifunctional cyanoacrylate monomers, including bifunctional cyanoacrylate monomers, are disclosed in the article entitled *"*Unequivocal Synthesis of Bis(2-cyanoacrylate) Monomers. Via Anthracene Adduct' by C. Buck, J. Polymer Sci, Polym. Chem Edition, Vol 16, 2475, (1978).

Bifunctional cyanoacrylate monomers may have the chemical formula (II): 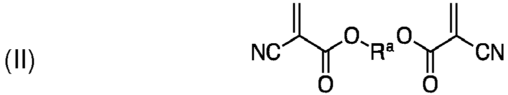 wherein R^{a} is selected from the group consisting of -(CH₂)ₙ with n = 2 to 12, -CH₂(C(CH₃)₂CH₂)-, -CH(CH₃)CH₂CH₂CH(CH₃)-, -CH₂C₆H₄CH₂- including 1,3- or 1,4-disubstituted aromatic), -(CH₂)₄O(CH₂)₄-, -CH₂(CF₂)₃CH₂-, - CH₂Si(CH₃)₂OSi(CH₃)₂CH₂-, -CH₂CH=CHCH₂- or -CH₂C≡CCH₂-.

Hybrid-functional cyanoacrylates, or simply 'hybrid cyanoacrylate' monomers may have the chemical formula (III): 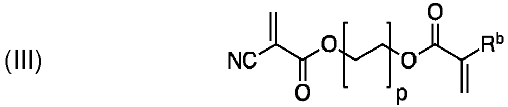 wherein R^{b} is -H or -CH₃; and wherein p is 1.

Hybrid cyanoacrylate monomers may have the chemical formula (IV): 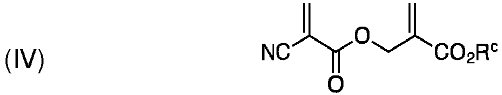 wherein R^{c} is -CH₃ or -C₂H₅.

Multifunctional cyanoacrylate monomers and hybrid-functional cyanoacrylates, optionally mixed with mono-functional cyanoacrylate monomers, are particularly suitable for obtaining 3D articles that are durable and that exhibit solvent resistance by virtue of crosslinking.

As defined herein before, the cyanoacrylate-based monomer may be selected from the group consisting of monomers of structure (I), monomers of structure (II), monomers of structure (III), monomers of structure (IV), and mixtures thereof.

The cyanoacrylate-based monomers may be low-odor or odorless monomers such as alkoxyalkyl cyanoacrylate esters.

The cyanoacrylate-based monomers may be low-staining or non-staining monomers.

The cyanoacrylate-based monomers may be selected from the group consisting of 2-methoxyethyl cyanoacrylate, 2-ethoxyethyl cyanoacrylate, 2-(1-alkoxy)propyl cyanoacrylate, 2-(2'-alkoxy)-methoxyethyl-2"-cyanoacrylate, 2-(2'-alkoxy)-ethoxyethyl-2"-cyanoacrylate, 2-(2'-alkoxy)-propyloxypropyl-2"-cyanoacrylate, 2-(2'-alkoxy)-butyloxybutyl-2"-cyanoacrylate, 2-(3'-alkoxy)-propyloxyethyl-2"-cyanoacrylate, 2-(3'-alkoxy)-butyloxyethyl-2"-cyanoacrylate, 2-(3'-alkoxy)-propyloxypropyl-2"-cyanoacrylate, 2-(3'-alkoxy)-butyloxypropyl-2"-cyanoacrylate, 2-(2'-alkoxy)-ethoxypropyl-2"-cyanoacrylate, 2-(2'-alkoxy)-ethoxybutyl-2"-cyanoacrylate, *n*-butyl cyanoacrylate, sec-butyl cyanoacrylate, iso-butyl cyanoacrylate, *n*-pentyl cyanoacrylate, 1-methylbutyl cyanoacrylate, 1-ethylpropyl cyanoacrylate, *n*-hexyl cyanoacrylate, 1-methylpentyl cyanoacrylate, *n*-heptyl cyanoacrylate, *n*-octyl cyanoacrylate, 2-octyl cyanoacrylate, 2-ethylhexyl cyanoacrylate, *n*-nonyl cyanoacrylate, *n*-decyl cyanoacrylate, *n-*undecyl cyanoacrylate, *n*-dodecyl cyanoacrylate, cyclohexyl cyanoacrylate, *n-*octadecyl cyanoacrylate, methyl cyanoacrylate, ethyl cyanoacrylate, n-propyl cyanoacrylate, iso-propyl cyanoacrylate, trimethylsilyethyl cyanoacrylate, trimethylsilypropyl cyanoacrylatetrimethylsilyloxyethyl cyanoacrylate triethylsilyloxyethyl cyanoacrylate phenylethyl cyanoacrylate, phenoxyethyl cyanoacrylate, and mixtures thereof.

If present, the alkoxy group is selected from the group consisting of methoxy, ethoxy, propyloxy, butyloxy, pentyloxy or hexyloxy. A suitable 2-(1-alkoxy)propyl cyanoacrylate may be 2-(1-methoxy)propyl cyanoacrylate. A suitable 2-(2'-*alkoxy*)-methoxyethyl-2"-cyanoacrylate may be 2-(2'-methoxy)-methoxyethyl-2"-cyanoacrylate. Suitable 2-(2'-alkoxy)-ethoxyethyl-2"-cyanoacrylates may be 2-(2'-methoxy)-ethoxyethyl-2"-cyanoacrylate, 2-(2'-ethoxy)-ethoxyethyl-2"-cyanoacrylate, 2-(2'-propyloxy)-ethoxyethyl-2"-cyanoacrylate, 2-(2'-butoxy)-ethoxyethyl-2"-cyanoacrylate, 2-(2'-pentyloxy)-ethoxyethyl-2"-cyanoacrylate, 2-(2'-hexyloxy)-ethoxyethyl-2"-cyanoacrylate. Suitable 2-(2'-alkoxy)-propyloxypropyl-2"-cyanoacrylates may be 2-(2'-methoxy)-propyloxypropyl-2"-cyanoacrylate, 2-(2'-ethoxy)-propyloxypropyl-2"-cyanoacrylate, 2-(2'-propyloxy)-propyloxypropyl-2"-cyanoacrylate, 2-(2'-butyloxy)-propyloxypropyl-2"-cyanoacrylate, 2-(2'-pentyloxy)-propyloxypropyl-2"-cyanoacrylate, 2-(2'-hexyloxy)-propyloxypropyl-2"-cyanoacrylate. Suitable 2-(2'-alkoxy)-butyloxybutyl-2"-cyanoacrylates may be 2-(2'-methoxy)-butyloxybutyl-2"-cyanoacrylate, 2-(2'-ethoxy)-butyloxybutyl-2"-cyanoacrylate, 2-(2'-butyloxy)-butyloxybutyl-2"-cyanoacrylate. A suitable 2-(3'-alkoxy)-propyloxyethyl-2"-cyanoacrylate may be 2-(3'-methoxy)-propyloxyethyl-2"-cyanoacrylate. A suitable 2-(3'-alkoxy)-butyloxyethyl-2"-cyanoacrylate may be 2-(3'-methoxy)-butyloxyethyl-2"-cyanoacrylate. A suitable 2-(3'-alkoxy)-propyloxypropyl-2"-cyanoacrylate may be 2-(3'-methoxy)-propyloxypropyl-2"-cyanoacrylate. A suitable 2-(3'-methoxy)-butyloxypropyl-2"-cyanoacrylate may be 2-(3'-alkoxy)-butyloxypropyl-2"-cyanoacrylate. A suitable 2-(2'-alkoxy)-ethoxypropyl-2"-cyanoacrylate may be 2-(2'-methoxy)-ethoxypropyl-2"-cyanoacrylate. A suitable 2-(2'-alkoxy)-ethoxybutyl-2"-cyanoacrylate may be 2-(2'-methoxy)-ethoxybutyl-2"-cyanoacrylate.

In one embodiment, the mono-functional cyanoacrylate monomers may be selected from 2-methoxyethyl cyanoacrylate, methyl cyanoacrylate, ethyl cyanoacrylate, n-propyl cyanoacrylate, iso-propyl cyanoacrylate or mixtures thereof; preferably from 2-methoxyethyl cyanoacrylate, methyl cyanoacrylate or mixtures thereof.

In another embodiment, the cyanoacrylate-based monomer is a mixture of at least one mono-functional cyanoacrylate monomer and at least one other cyanoacrylate-based monomer; wherein the mono-functional cyanoacrylate monomers is selected from 2-methoxyethyl cyanoacrylate, methyl cyanoacrylate, ethyl cyanoacrylate, n-propyl cyanoacrylate, iso-propyl cyanoacrylate or mixtures thereof; preferably from 2-methoxyethyl cyanoacrylate, methyl cyanoacrylate or mixtures thereof; and wherein the at least one other cyanoacrylate-based monomer is selected from monomers of structure (II), monomers of structure (III), monomers of structure (IV), and mixtures thereof.

Suitable processes for preparing cyanoacrylate-based monomers are particularly disclosed in the US patent US 2,467,927 and in the US patent US 9,670,145.

The liquid resin may comprise from 45 to 100 % by weight, preferably from 70 to 98% by weight, more preferably from 90 to 98% by weight, of cyanoacrylate-based monomers, by total weight of the liquid resin.

The liquid resin may comprise from 1 to 25 % by weight, preferably from 3 to 15% by weight, more preferably from 5 to 10% by weight, of multifunctional cyanoacrylate monomers and/or hybrid cyanoacrylate monomers, by total weight of the polymerizable monomers.

### Additional photopolymerizable monomers

In addition to cyanoacrylate monomers, the liquid resin may also comprise additional photopolymerizable monomers, preferably (meth)acrylate monomers. US application 2018/215973 describes suitable (meth)acrylate monomers.

The (meth)acrylate monomers may be selected from the group consisting of monofunctional (meth)acrylate monomers, polyfunctional acrylate monomers, and mixtures thereof. The monofunctional (meth)acrylate monomers may be selected from linear or branched alkyl, alkoxylakyl, furfuryl, isobornyl, glycidyl, or phenoxyethyl, esters and the cyclic and heterocyclic esters. Suitable monofunctional acrylate monomers are commercially available under the denominations SR-531, SR-789 from Sartomer. The polyfunctional (meth)acrylate monomers may be selected from the group consisting of butanediol di(meth)acrylate, hexanediol di(meth)acrylate, diethylene glycol di(meth)acrylate, triethyleneglycol di(meth)acrylate, polyethylene glycol di(meth)acrylate, trimethylolpropane tri(meth)acrylate (TMPTA), ethoxylatedtrimethylolpropane tri(meth)acrylate, neopentylglycoldiacrylate, pentaerythritoltetraacrylate (PETA), pentaerythritoltetramethacrylate (PETMA), dipentaerythritolpenta(meth)acrylate, dipentaerythritolhexa(meth)acrylate, bisphenol-A-diacrylate, bisphenol-A-dimethacrylate, ethoxylatedbisphenol-A-diacrylate, tricyclodecane dimethanol diacrylate (commercially available as Sartomer SR833S), propoxylatedbisphenol-A-diacrylate, and mixtures thereof. Polyfunctional (meth)acrylic esters may be of relatively low molecular weight such as the commercially available, triethylene oxide dimethacrylate, or butanedioldimethacrylate, or may be of higher molecular weight: (meth)acrylic functionalized oligomers and (meth)acrylic functionalized resins, for example (meth)acrylic ester terminated polymers, such as (meth)acrylic terminated polyesters or urethane polymers or copolymers or so-called (meth)acrylic ester functionalised telechelic, dendrimeric or hyperbranched materials. Suitable (meth)acrylic monomers are commercially available from Sartomer, Arkema and BASF, such as for example SR-341, SR-833S, SR-508 and SR-834 from Sartomer.

The liquid resin may comprise from 5 to 50% by weight of additional photopolymerizable monomers, by total weight of the mixtures of photopolymerizable monomers.

In an alternative embodiment, the liquid resin may be substantially free of photopolymerizable monomers other than cyanoacrylate-based monomers. By "substantially free of" is meant a liquid resin comprising 1 % by weight or less, preferably 0.1 % by weight or less, more preferably 0.01 % by weight or less, most preferably 0 % by weight (free), of additional photopolymerizable monomers by total weight of the liquid resin.

### Resin-immiscible liquid

A resin-immiscible liquid may be provided in CLIP methods.

This liquid is immiscible to the liquid resin, particularly to the cyanoacrylate-based monomers.

When present, the resin-immiscible liquid is held in the tank, and both the liquid resin and the resin-immiscible liquid forms a bilayer volume, wherein the latter is below the former.

The resin-immiscible liquid may comprise acidic inhibitors or be inherently acidic.

### Acidic inhibitors

The printing system comprises a source of acidic inhibitors, for providing acidic inhibitors to the liquid resin.

In the present application the terms "acidic inhibitors", "inhibitors of photopolymerization" and "stabilizers against photopolymerization" are used interchangeably. The acidic inhibitors aim at stabilizing the liquid resin comprising the cyanoacrylate-based monomers, thus avoiding unwanted polymerization, absent from any light exposure, and also for maintaining prevention of the polymerization outside the polymerization zone i.e. in the remaining part of the liquid resin where no polymerization is expected (for example in the dead zone of CLIP methods or within projected patterns of volumetric methods).

The acidic inhibitors may be selected from the group consisting of Lewis acids, Bronsted acids, acids provided from an acidic ion exchange material or photoacids obtained from photoacid generators (also known as PAGs).

Lewis acids are non-protonic acids, which may be selected from the group consisting boron trifluoride and derivatives, fluoroboric acid, sulphur dioxide, and mixtures thereof; preferably from the group consisting of boron trifluoride, boron trifluoride etherate complex, boron trifluoride dihydrate complex, boro trifluoride tetrahydrofuran complex, trimethylsilyl triflate, sulphur dioxide, and mixtures thereof; more preferably the Lewis acid is etherate complex. In some embodiments, Lewis acids preferably are volatile acids such as boron trifluoride or its complexes or sulphur dioxide.

Bronsted acids may be selected from the group consisting of alkyl sulfonic acids such as methanesulfonic acid, ethanesulfonic acid, p-toluenesulfonic acid, (linear or) alkylbenzene sulfonic acid, hydrofluoric acid, trichloro- or trifluoro- acetic acids; preferably sulfonic acids; more preferably methane sulfonic acid.

Acids provided from an acidic ion exchange material, such as a membrane, may be in the form of free sulfonic acids. Hence, the cyanoacrylate-based monomers may be inhibited by intimate contact with a separate substance comprising sulfonic acids groups during the printing method.

Photoacid generators may be selected from the group consisting of phenyl-substituted onium salts, arylsulfonate esters, *o*-nitrobenzyl-based PAG, imino and imidosulfonates, merocyanine-based PAG, terarylene-based PAG, and mixtures thereof. Phenyl-substituted onium salts, with anions that produce superacids, may be selected from the group consisting of bis(4-*tert-*butylphenyl)iodonium hexafluorophosphate, cyclopropyldiphenylsulfonium tetrafluoroborate, dimethylphenacylsulfonium tetrafluoroborate, diphenyliodonium hexafluorophosphate, diphenyliodonium hexafluoroarsenate, diphenyliodonium trifluoromethane sulfonate, 4-isoproyl-4'-methyldiphenyliodonium tetrakis(pentafluorophenyl)borate, 4-nitrobenzenediazonium tetrafluoroborate, triphenylsulfonium tetrafluoroborate, tri-*p*-tolylsulfonium hexafluorophosphate, tri-*p*-tolylsulfonium trifluoromethanesulfonate, bis(4-tert-butylphenyl)iodonium bis-perfluorobutanesulfonyl imide. Suitable Photoacid generators may be available from Fujifilm Wako Pure Chemical Co., and TCI America Chem Co. Bis(4-*tert-*butylphenyl)iodonium hexafluorophosphate is commercially available under the denomination Speedcure^{®} 938 from Lambson Ltd. In a preferred embodiment, phenyl-substituted onium salts can be used in the wavelength range of 350-2500 nm when used alone and/or in combination with photosensitizers (see examples in Progress in Polymer Science; Volume 65, February 2017, Pages 1-41). Hence, the cyanoacrylate-based monomers may be inhibited by the purposeful photogeneration of inhibiting acid during the printing process, particularly by ensuring that the wavelengths for photopolymerization and photoinhibition are non-interfering.

The acidic inhibitors may be provided in any suitable manner. The source of acidic inhibitors may be present originally in the liquid resin, it may be located below the tank but be accessible to the tank contents, it may be inside the below compartment of the tank, it may be inside a liquid or wettable optically transparent material or it may be inside a resin-immiscible liquid. These different sources of acidic inhibitors are not necessarily exclusive from each other and may be used in combination. Whatever the sources of acidic inhibitors and their location, the acidic inhibitors should be provided to the liquid resin at a sufficient concentration for stabilizing the cyanoacrylate-based monomers and for preventing unwanted polymerization, prior to light exposure and also outside the polymerization zone under light exposure.

The liquid resin comprises acidic inhibitors. In a preferred embodiment, the liquid resin comprises from 5 from 100 parts per million (ppm), more preferably from 8 from 90 ppm, still more preferably from 10 from 80 ppm, of acidic inhibitor by total weight of the liquid resin. When present in the liquid resin, the acidic inhibitors may be selected from Lewis acid, Bronsted acids or combinations thereof.

The acidic inhibitors are present originally in the liquid resin as a sole or primary source of acidic inhibitors. The presence of acidic inhibitors as the sole source of acidic inhibitors is particularly suitable for volumetric 3D printing methods. The presence of acidic inhibitors as a primary source of acidic inhibitors is particularly suitable for continuous linear 3D and layer-by-layer printing methods.

The system may comprise a secondary source of acidic inhibitors i.e. a source of acidic inhibitors being different from the acidic inhibitors originally present in the liquid resin.

The acidic inhibitors may diffuse to the volume of liquid resin from/through a semipermeable membrane. The semipermeable membrane may be the optically transparent portion. In such case, the source of acidic inhibitors would be located below the tank. The semipermeable membrane may alternatively be a partition wall, if present. In such case, the source of acidic inhibitors would be located inside the lower compartment of the tank. In these embodiments, the acidic inhibitors may be volatile Lewis acids. Hence, the cyanoacrylate-based monomers are inhibited by the vapour of the Lewis acid during the printing process.

The acidic inhibitors may be in contact with the volume of liquid resin from a liquid or wettable, optically transparent material overlying the inner surface of the optically transparent portion of the tank.

A resin-immiscible liquid, also held in the tank, may be provided. The acidic inhibitors may be in contact with the liquid resin at the interface with the resin-immiscible liquid.

An additional light, of a different wavelength than the light selectively polymerizing the liquid resin, may be emitted and transmitted to the liquid resin comprising for example latent PAGs, and the acidic inhibitors may be thus generated in the volume elements (voxels) of liquid resin by said additional light.

### Photoinitiation

The liquid resin comprises a source of photoinitiators. Photoinitiators promote photopolymerization. The terms "photoiniator" and "photoinitiator system" are used interchangeably presently. A suitable photoinitiator system, part of which comprises radical photoinitiators, is disclosed in the PCT application WO 2017/021785 A1. Photoinitiators may also act directly on any additional photopolymerizable monomers, such as typical acrylates, that may be admixed with cyanoacrylate-based monomers in the liquid resin.

A suitable source of photoinitiators comprises a metallocene component (also called "synergist"), preferably a metallocene compound selected from the group consisting of 'sandwich compounds' such as ferrocene compounds, ruthenocene compounds, bis(cyclopentadieneyl) osmium compounds their derivatives thereof, and mixtures thereof; preferably the metallocene compound is a ferrocene compound, its derivatives thereof, and mixtures thereof.

The ferrocene compound of formula may be a compound of formula (V) 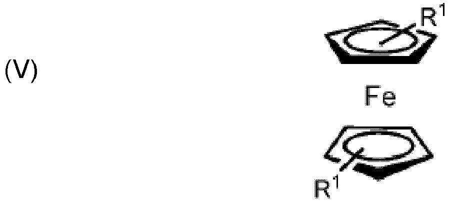 wherein R¹ is a hydrogen or a C₁₋₄ alkyl group, and wherein one or more R¹ are present in one or both rings. Suitable ferrocene compounds are disclosed in US patents 5,824,180 and 6,503,959.

The liquid resin may comprise from 100 to 1000 ppm (parts per million), preferably from 150 to 500 ppm, more preferably from 200 to 300 ppm, of a ferrocene compound of formula (V) by total weight of the liquid resin.

This suitable source of photoinitiators also comprises an additional photoinitiator.

The additional photoinitiator may be selected from the group consisting of phenyl-substituted acyl phosphines, alpha diketones, thioxanthones, alpha-hydroxy ketones, benzyldimethylketals, phenylglyoxylates, camphorquinone, acylgermane compounds, dialkylsilylglyoxylates, and mixtures thereof. The additional photoinitiators are particularly useful for increasing the speed of the polymerization of the cyanoacrylate-based monomers.

The acylgermane compound may be selected from the group consisting of the compounds of formula (VI) 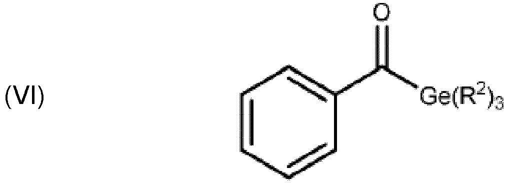
wherein R² is a methyl or a phenyl group;
the compounds of formula (VII) 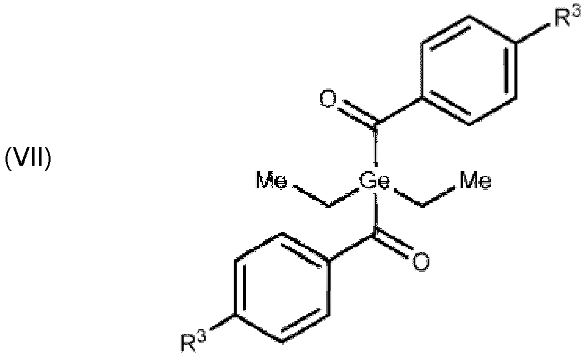
wherein R³ is hydrogen or a methoxy group; and,
mixtures thereof.

Suitable additional photoinitiators are commercially available under the denominations Irgacure^{®} 819 (BASF) or Darocur^{®} TPO (BASF) for phenyl-substituted acyl phosphines; Irgacure^{®} 184/500/2959 (BASF) or Darocur^{®} 1173 (BASF) for alpha-hydroxy ketones; Irgacure^{®} 651 (BASF) for benzyldimethylketals, Irgacure^{®} 754 (BASF) or Darocur^{®} MBF (BASF) for phenylglyoxylates; from Sigma-Aldrich Merck for camphorquinone; under the denomination Ivocerin^{™} from Ivoclar KGaA& AC Co. for acyl germane compounds; and from Sigma-Aldrich Merck for dialkylsilylglyoxylates.

In a preferred embodiment, the liquid resin comprises the combination of metallocene compounds and radical photoinitiators. Said combination transforms photoinitiation efficiency dramatically.

In another preferred embodiment, the liquid resin comprises a ferrocene compound of formula (V), and an acylgermane compound selected from the group consisting of the compounds of formulas (VI) and/or (VI); preferably the liquid resin comprises from 100 to 300 ppm of a ferrocene compound of formula (V), and from 600 to 900 ppm of an acylgermane compound selected from the group consisting of the compounds of formulas (VI) and/or (VI). For example, in a CAL method embodiment, it may be used a 18 mm tank and the liquid resin may comprise from 50 to 150 ppm of a ferrocene compound of formula (V), and from 100 to 300 ppm of an acylgermane compound selected from the group consisting of the compounds of formulas (VI) and/or (VI).

In another preferred embodiment, the liquid resin comprises a ferrocene compound of formula (V), and a camphorquinone.

The liquid resin may comprise from 0.1 to 2 % by weight, preferably from 0.5 to 2 % by weight, more preferably from 1 to 2 % by weight, of an additional photoinitiator by weight of the total composition.

### Additional compounds

The liquid resin may also comprise additional compounds, particularly compounds selected from the group consisting of radical stabilizers, photosentizers, etc.

### Radical stabilizers

The liquid resin may also comprise radical stabilizers.

The radical stabilizers may be selected from the group consisting of hydroquinone, hydroquinone monomethyl ether, hydroxytoluene butyl ether, hydroxyanisole, and mixtures thereof. Radical stabilizers help extending product shelf life, particularly when additional photopolymerizable monomers, such as (meth)acrylate monomers are present in the liquid resin

The liquid resin may comprise from 0.001 % to 0.2 % by weight, preferably from 0.005 % to 0.1 %, more preferably from 0.002 % to 0.06 % by weight, of radical stabilizers by total weight of the liquid resin.

### Photosensitizers

The liquid resin may also comprise a photosensitizer.

The photosensitizer may be thioxanthone compound. Suitable materials are commercially available under the denomination SpeedCure CPTX from Lambson Ltd. For example, 1-chloro-4-propyl thioxanthone is a suitable compound, that is sensitive in a wavelength range from 380 to 420 nm, preferably from 395 to 405 nm. It can be used in combination with bis(4-tert-butylphenyl)iodonium hexafluorophosphate.

The liquid resin may comprise from 0.1 % to 5 % by weight, preferably from 0.2 % to 3 %, more preferably from 0.5 % to 2.5 % by weight, of photosensitizers by total weight of the liquid resin.

### Thickeners

The liquid resin may also comprise thickeners. Thickeners are particularly suitable for controlling and/or increasing the viscosity of the liquid resin, considering that cyanoacrylate-based monomers usually have a water-like viscosity at ambient temperature.

Suitable thickeners may be selected from the group consisting of poly(meth)acrylates, *acylated cellulose polymers* (*e.g.* cellulose acetate), polyvinyl acetates, partially hydrolysed polyvinyl acetates, polyvinylpyrrolidones, polyoxylates, polycaprolactones, polycyanoacrylates, vinyl acetate copolymers (*e*.*g*. with vinyl chloride), copolymers of (meth)acrylates with butadiene and styrene, copolymers of vinyl chloride and acrylonitrile, copolymers of ethylene and vinyl acetate, poly(butyleneterephthalate-co-polyethyleneglycolterephthalate), copolymers of lactic acid and caprolactone, and mixtures thereof.

Preferably, the thickeners are selected from the group consisting of polymethylmethacrylate, polycyanoacrylates, copolymers of vinyl acetate and vinyl alcohol, copolymers of vinyl chloride and vinyl acetate, copolymers of ethylene, vinyl acetate, and esters or partial esters of maleic acid, and mixtures thereof. Suitable materials are commercially available under the denomination Degacryl^{®} M 449 from Evonik (polymethylmethacrylate), Levamelt^{®} 900 from Lanxess (copolymers of vinyl acetate and vinyl alcohol), Vinnol^{®} H 40-60 from Wacker (copolymers of vinyl chloride and vinyl acetate), and Vamac^{®} G from DuPont (copolymers of ethylene, vinyl acetate, and esters or partial esters of maleic acid).

The liquid composition may comprise from 2% to 10% by weight, preferably from 3% to 8% by weight, and more preferably from 4% to 7% by weight, of thickeners by total weight of the liquid resin.

### Thixotropic agent

The liquid resin may also comprise thixotropic agents.

The thixotropic agent may be silica, preferably fumed silica, more preferably hydrophobic fumed silica. Hydrophobic fumed silica may also acts as a filler. A hydrophobic fumed silica is commercially available under the commercial denomination Aerosil^{®} R202 from Evonik. The thixotropic agent may also be organic-based thixotropic agents, preferably hydrogenated castor oil.

The liquid resin may comprise from 2% to 10% by weight, preferably from 3% to 8% by weight, more preferably from 4% to 7% by weight, of thixotropic agents by total weight of the liquid resin.

### Fillers and pigments

In addition to hydrophobic fumed silica if present, the liquid composition may also comprise other fillers and pigments, preferably acid-treated fillers and pigments, more preferably organo-silicone modified surface-treated pigments and fillers. Other fillers and pigments should be compatible with cyanoacrylate-based monomers and not excessively impede the photopolymerization where desired, especially in the CAL method. In some cases, pigments may be used to limit excessive light penetration or 'read through' that could limit resolution of printed elements. US patents 4,837,260 and 4,980,086, and US patent applications 2005/0171273 and 2008/0038218 describe cyanoacrylate-compatible fillers.

The liquid resin may comprise from 0.1 to 5 % by weight of other fillers and pigments by total weight of the composition.

### Toughening agents

The liquid resin may also comprise toughening agents.

The toughening agents may be selected from the group consisting of block copolymers (*e*.*g*. polymethylmethacrylate-co-Polybutylacrylate-co-Polymethylmethacrylate, elastomeric rubbers, elastomeric polymers, liquid elastomers, polyesters, acrylic rubbers, butadiene/acrylonitrile rubber, Buna rubber, polyisobutylene, polyisoprene, natural rubber, synthetic rubber (*e*.*g*. styrene/butadiene rubber or SBR), polyurethane polymers, ethylene-vinyl acetate polymers, fluorinated rubbers, isoprene-acrylonitrile polymers, chlorosulfonated polyethylenes, homopolymers of polyvinyl acetate, block copolymers, core-shell rubber particles, and mixtures thereof.

The liquid resin may comprise from 1 to 20 % by weight, preferably from 5 to 12 % by weight, of toughening agents by total weight of the composition.

### Plasticizers

The liquid resin may also comprise plasticizers, such a glycerol triacetate and dibutylsebacate.

The liquid resin may comprise from 5 to 20% by weight of plasticizers by total weight of the liquid resin.

### Rinsing solvent

The obtained 3D article made of polymerized resin may be treated with a non-nucleophilic rinsing solvent. The treatment of the 3D article with the non-nucleophilic rinsing solvent corresponds to a postprocessing step (or a rinsing step), allowing rinsing off the excess liquid resin and thus the unpolymerized cyanoacrylate-based monomers, without dissolving the polymerized parts of the 3D article.

The treatment of the 3D article with the non-nucleophilic rinsing solvent is carried immediately following completion of printing, and optionally before exposing the article to an additional source of light for rending the 3D article non-tacky.

3D articles obtained from formulations comprising exclusively one or more mono-functional cyanoacrylate monomers, may be rinsed with one non-nucleophilic rinsing solvent but not dissolved by it on a practical timescale (which is within seconds to minutes), and subsequently dissolved by another dissolving solvent, if later desired. This duality, depending on the solvent used, is possible because of the lack of crosslinking and the lack of higher functionality in mono-functional monomers. In such case, a suitable non-nucleophilic rinsing solvent for use in the postprocessing step would be a non-nucleophilic rinsing solvent that would not significantly dissolve the 3D article under usual rinsing conditions. Such suitability may be assessed with the test method as follows: 10 mL of selected rinsing solvent is not able to dissolve more than 1 % by weight of 0.5 g of a substantially spherical article (granule-shaped) made of non-thermosetting polycyanoacrylate (*i*.*e*. obtained exclusively from mono-functional cyanoacrylate monomers) after 5 min or less with 100 rpm stirring at ambient temperature.

3D articles obtained derived from formulations comprising multi-functional cyanoacrylate monomers and/or hybrid monomers, and optionally admixed with mono-functional cyanoacrylate monomers, may also be rinsed with a non-nucleophilic rinsing solvent.

The posttreatment step of rinsing with non-nucleophilic rinsing solvents using any type of cyanoacrylate-based formulation allows discharge of the unpolymerized monomers from the vat.

The non-nucleophilic rinsing solvent may be selected from the group consisting of non-basic solvents, non-ionic solvents (or solutions) and mixtures thereof. The solvent may not be selected from basic solvents, nucleophilic solvents, ionic solvents (or solutions) and mixtures thereof, as such solvents may initiate the polymerization of the free (unpolymerized) cyanoacrylate-based monomers present in the excess liquid resin.

The non-nucleophilic rinsing solvents may be selected from the group consisting of hydrocarbon and perfluorinated hydrocarbon solvents, ether solvents, acetate solvents, chlorohydrocarbon solvents, polar aprotic solvents, and mixtures thereof. Suitable hydrocarbon non-nucleophilic solvents may be selected from pentane, hexane, benzene, toluene, and mixtures thereof. Suitable ether solvents may be selected from 1,4-dioxane, diethyl ether, tetrahydrofuran, and mixtures thereof. A suitable non-nucleophilic chlorohydrocarbon solvents may be chloroform. Suitable polar aprotic non-nucleophilic solvents may be selected from dichloromethane, ethyl acetate, acetone, acetonitrile, dimethyl sulfoxide, nitromethane, propylene carbonate, and mixtures thereof.

Exemplary non-nucleophilic rinsing solvents may be perfluorooctane and/or propylene glycol monomethyl ether acetate (PGMEA).

When the 3D article (polyMECA) is exclusively obtained from 2-methoxyethyl cyanoacrylate monomers, the posttreatment step is preferably carried out with perfluorooctane, PGMEA or mixtures thereof. Isopropanol, for example is not recommended for use.

When the 3D article (polyECA) is exclusively obtained from ethyl cyanoacrylate monomers, the posttreatment step is preferably carried out with perfluorooctane, PGMEA or mixtures thereof. Isopropanol, for example is not recommended for use.

When the 3D article (polyMCA) is exclusively obtained from methyl cyanoacrylate monomers, the posttreatment step is preferably carried out with perfluorooctane, PGMEA or mixtures thereof. Isopropanol is not recommended for use.

The rinsing solvent may be substantially free of any basic solvents, nucleophilic solvents, ionic solvents (or solutions) and mixtures thereof. The solvent may be substantially free of any polar aprotic solvents. The solvent may be substantially free of water. By "substantially" is meant that the solvent comprises 1 % or less, preferably 0.1 % or less, more preferably 0 % of a compound.

### Method for printing 3D articles

The method for printing a 3D article (or 3D printing method), according to the present invention, comprises the steps of:
a) providing a volume of liquid resin comprising cyanoacrylate-based monomers, a photoinitiator and an acidic inhibitor, held in a tank, said tank comprising at least one optically transparent portion;
b) defining/comprising a polymerization zone;
c) emitting and controlling light and transmitting it to the liquid resin through the optically transparent portion for selectively polymerizing the liquid resin in the polymerization zone;
d) obtaining a three-dimensional article made of polymerized resin;
e) treating the obtained 3D article with a non-nucleophilic rinsing solvent for removing the liquid resin in excess; and
f) optionally exposing the obtained three-dimensional article to an additional light source for rendering the article non-tacky.

In an embodiment, the method for printing a three-dimensional (3D) article, comprises the steps of: a) providing a volume of liquid resin comprising cyanoacrylate-based monomers and a photoinitiator, held in a tank, said tank comprising at least one optically transparent portion; b) defining a polymerization zone; c) emitting and controlling light and transmitting it to the liquid resin through the optically transparent portion for selectively polymerizing the liquid resin in the polymerization zone; d) concurrently preventing the polymerization of the monomers using acidic inhibitors outside the polymerization zone; e) obtaining a three-dimensional article made of a polymerized resin; f) treating the obtained 3D article with a non-nucleophilic rinsing solvent; and optionally exposing the obtained three-dimensional article to an additional light source for rendering the article non-tacky. In an embodiment, the three-dimensional printing system comprises: a) a volume of liquid resin comprising cyanoacrylate-based monomers and a photoinitiator, said volume defining a polymerization zone; b) a tank for holding the volume of liquid resin, said tank comprising at least one optically transparent portion; c) a light source emitting light for selectively polymerizing the liquid resin in the polymerization zone; d) a source of acidic inhibitors for preventing the polymerization of the monomers outside the polymerization zone; f) a source of a non-nucleophilic rinsing solvent; and g) optionally an addition light source emitting light for rendering the article non-tacky.

The liquid resin, the cyanoacrylate-based monomers, a photoinitiator systems, the acidic inhibitors and any other materials are described above. The presence of the acidic inhibitors in the liquid resin (as the sole or as a primary source of acidic inhibitors) as well as the optional provision of a secondary source of acidic inhibitors are suitable for stabilizing the cyanoacrylate-based monomers and for preventing unwanted polymerization, prior light exposure and also outside the polymerization zone under light exposure. Hence, the provision of a volume of liquid resin comprising an acidic inhibitor and the optional provision of an additional source of acidic amounts to the provision of the step of concurrently preventing the polymerization of the monomers using acidic inhibitors outside the polymerization zone i.e. under light exposure.

In some embodiments, such as layer-by-layer printing methods and continuous printing methods including CLIP and ILI methods, the optically transparent portion corresponds to the bottom wall of the tank, and the light is emitted from below the tank, through its bottom surface, into the volume resin. A platform, preferably moveably mounted on an arm, is provided from above the tank, and is submerged into the volume of liquid resin. The bottom surface of the platform is positioned at a specific distance above the top surface of the optically transparent portion, thereby forming a space comprised of liquid resin.

The step of treating the 3D article with a non-nucleophilic rinsing solvent is a postprocessing step (rinsing step). This step is carried out during a short period of time i.e. the time during which the non-nucleophilic solvent is in contact with the 3D article. The non-nucleophilic rinsing solvent may be in contact with the 3D article for 10 minutes or less, preferably for 5 minutes or less, more preferably for 3 minutes or less.

In one embodiment, the step of treating the 3D article with a non-nucleophilic rinsing solvent is carried out by dipping the 3D article into the non-nucleophilic solvent for a period of 15 seconds or less. This dipping step is advantageous in that it allows removing the excess liquid resin, and any unpolymerized monomers, in a very short period of time.

During the postprocessing step, the excess liquid resin (and thus the unpolymerized cyanoacrylate monomers) is rinsed off, while there is no dissolution of the polycyanoacrylate forming the 3D article.

The step of exposing the 3D article to an additional light source is suitable for rendering the 3D article non-tacky.

This step may be carried out at a wavelength from 380 nm to 470 nm.

The step may be carried using ambient light or any suitable light device, including for example a LED. Suitable LED would include low intensity, such as LED having an irradiance from 5 to 50 mW/cm².

This step is carried out during a short period of time *i.e*. the time during which the 3D article is exposed to the light. The 3D article may be exposed to light for 60 seconds or less, preferably from 1 to 30 seconds, more preferably from 1to 20 seconds.

The 3D printing method may comprise the following additional steps. Some of these steps may depend on specific methods and/or conditions, as indicated herein before.

The method may comprise the step of providing a tank comprising an optically transparent portion and forming at least one compartment for holding the liquid resin.

The method may comprise the step of rotatably moving the tank in the vertical Z axis.

The method may comprise the step of treating the inner surface of the optically transparent portion, in contact with the liquid resin, for preventing adhesion of the polymerized resin to it.

The method may comprise the step of controlling the emission of the light using a light-controlling device. Particularly, the method may comprise the step of interposing the light-controlling device between the light source and the optically transparent portion.

The method may comprise the step of emitting an additional light, having a different wavelength, for photoinhibiting the polymerization.

The method may comprise the step of providing a platform moveably mounted on an arm, for enabling its motion along the vertical Z axis.

The method may comprise the step of providing an additional source of acidic inhibitors.

The method may comprise the step of diffusing the acidic inhibitor to the volume of liquid resin through the optically transparent portion, or alternatively through the partition wall.

The method may comprise the step of overlying the inner surface of the optically transparent portion of the tank with a liquid or wettable, optically transparent material. The method may further comprise the step of releasing the acidic inhibitor to the volume of liquid resin from the liquid or wettable, optically transparent material.

The method may comprise the step of providing a resin-immiscible liquid. The method may further comprise the step of releasing the acidic inhibitor to the volume of liquid resin from the resin-immiscible liquid.

The method may comprise the step of photogenerating the acidic inhibitor in the volume of liquid resin.

The method may comprise the step of providing a source of photoinitiators to the liquid resin comprising the combination of metallocene compounds and radical photoinitiators.

The 3D printing method may be computer-implemented in a conventional manner. This means that steps (or substantially all the steps) of the method are executed by at least one computer, or any system alike. Thus, steps of the method are performed by the computer, possibly fully automatically, or, semiautomatically. In examples, the triggering of at least some of the steps of the method may be performed through user-computer interaction. The level of user-computer interaction required may depend on the level of automatism foreseen and put in balance with the need to implement user's wishes. In examples, this level may be user-defined and/or pre-defined. For example, depending on the embodiments, the light intensity, the control of the light, the elevation of the platform, the rotation of the tank, the provision of the liquid resin and/or the provision of the acidic inhibitor may be executed by at least one computer, or any system alike.

### Layer-by layer 3D printing methods

The so-called "bottom-up" layer-by-layer 3D printing method may comprise the following steps:
a) providing a fixed tank comprising a bottom wall and at least one side wall forming a compartment, wherein at least one optically transparent portion is located on the bottom wall;
b) providing a volume of liquid resin comprising cyanoacrylate-based monomers, a photoinitiator system, and an acidic inhibitor, held in the tank;
c) providing a light source located below the tank;
d) optionally providing an additional source of acidic inhibitor;
e) providing a platform, immersing it in the liquid resin, and positioning its bottom surface at a specific distance from the optically transparent portion of the tank;
f) continuously exposing the liquid resin to light according to a defined pattern for defining a polymerization zone;
g) concurrently moving the platform upwards along the Z axis allowing the liquid resin to flow between the bottom layer of the first layer and the top surface of the optically transparent portion and then lowering the platform downwards to the specific distance between the bottom surface of the platform and the top surface of the optically transparent portion for photopolymerizing the first layer of the 3D article;
h) repeating step f) for photopolymerizing additional layers for printing the 3D article;
i) obtaining a three-dimensional article made of polymerized resin;
j) treating the obtained 3D article with a non-nucleophilic rinsing solvent for removing the liquid resin in excess (postprocessing step); and
k) optionally exposing the obtained three-dimensional article to an additional light source for rendering the article non-tacky.

### Continuous linear 3D printing methods

The continuous linear 3D printing methods may be selected from CLIP methods or ILI methods.

Continuous linear 3D printing methods such as CLIP and ILI methods may comprise the following steps:
a) providing a fixed tank comprising a bottom wall and at least one side wall forming a compartment, wherein at least one optically transparent portion is located on the bottom wall;
b) providing a volume of liquid resin comprising cyanoacrylate-based monomers, a photoinitiator system, and an acidic inhibitor, held in the tank;
c) providing a light source located below the tank;
d) optionally providing an additional source of acidic inhibitor;
e) providing a platform, immersing it in the liquid resin, and positioning its bottom surface at a specific distance from the optically transparent portion of the tank;
f) continuously exposing the liquid resin to light according to a defined pattern for defining a polymerization zone;
g) concurrently moving the platform upwards at a specific elevation rate for progressively photopolymerizing the liquid resin;
h) treating the obtained 3D article with a non-nucleophilic rinsing solvent for removing the liquid resin in excess (postprocessing step); and
i) optionally exposing the obtained three-dimensional article to an additional light source for rendering the article non-tacky.

In a preferred embodiment, a dead zone is formed, which is sandwiched between the optically transparent portion and the polymerization zone. The dead zone is the zone in contact with the optically transparent portion, wherein the resin does not polymerize, even when exposed to light. In addition of conventional means such as coatings as well as the acidic inhibitors present in the liquid resin, the dead zone may further be obtained by providing the additional source of acidic inhibitors. When the method comprises the step of providing an additional source of acidic inhibitors, the tank may comprise a partition wall, such as a semi-permeable membrane, for dividing the tank into two compartments i.e. a top compartment and a bottom compartment. Alternatively, the inner surface of the optically transparent portion of the tank may be overlaid with a liquid or wettable, optically transparent material, such as a membrane. Alternatively, the tank may further comprise a resin-immiscible liquid. In such case, the provision of the additional acidic inhibitors from the bottom of the compartment holding the liquid resin (*e*.*g*. the optically transparent portion, a semipermeable membrane, a surface of the liquid or a wettable, optically transparent material or the resin-immiscible liquid) creates a gradient of acidic inhibitors, thereby inhibiting the photoinhibition in the vicinity of the bottom of the compartment holing the liquid resin, in an analogous way to oxygen used in conventional 3D printing methods relying on radical photopolymerization.

### Volumetric 3D printing methods

Volumetric 3D printing methods may comprise the following steps:
a) providing a tank, rotatably moveable around a vertical Z axis, comprising a bottom wall and at least one side wall forming a compartment, wherein at least one optically transparent portion is located on the side wall of the tank;
b) providing a volume of liquid resin comprising cyanoacrylate-based monomers, a photoinitiator system, and an acidic inhibitor, held in the tank;
c) providing a light source located at least on one the side of the tank;
d) optionally providing an additional source of acidic inhibitor;
e) exposing the liquid resin to at least a first set of light, either continuously or at a specific sequence for progressively photopolymerizing the liquid resin;
f) concurrently rotating the tank at a at a specific rotation rate;
g) obtaining a three-dimensional article made of polymerized resin; and
h) treating the obtained 3D article with a non-nucleophilic rinsing solvent for removing the liquid resin in excess (postprocessing step); and
i) optionally exposing the obtained three-dimensional article to an additional light source for rendering the article non-tacky.

The volumetric 3D printing methods are selected from the CAL method or the dual-wavelength volumetric photopolymerization method.

In a preferred embodiment, the volumetric 3D printing method does not comprise the step of providing an additional source of acidic inhibitors.

### 3D printed articles

3D printed articles are obtained by the present 3D printing method.

The 3D printed article, according to the present invention, is made, at least partly, of polycyanoacrylate. The 3D printed article may comprise from 50 % by weight of polycyanoacrylate, by total weight of the article. The 3D printed article may comprise from 55 %, or from 60 %, or from 65 %, or from 70 %, or from 75 %, or from 80 %, or from 85 %, or from 90 %, or from 95 % by weight of cyanoacrylate by total weight of the article. The 3D printed article may comprise up to 95 % by weight of polycyanoacrylate, by total weight of the article. The 3D printed article may comprise up to 90 %, or up to 85 %, or up to 80 %, or up to 75 % by weight of polycyanoacrylate, by total weight of the article. In one embodiment, the 3D printed article may be substantially free of another polymer other than polycyanoacrylate. By "substantially free of" is meant an article comprising 1 % by weight or less, preferably 0.1 % by weight or less, more preferably 0.01 % by weight or less, most preferably 0 % by weight (free), of another polymer other than polycyanoacrylate.

By "3D printed articles" is meant unmoulded articles. By "polycyanoacrylate" is meant homopolymer(s) obtained from the polymerization of distinct cyanoacrylate-based monomers, or copolymers of mixed cyanoacrylate-based monomers. Optionally additional photopolymerizable monomers, such as (meth)acrylate monomers may copolymerise with cyanoacrylate-based monomers.

In one embodiment, the 3D printed articles are exclusively obtained from mono-functional cyanoacrylate-based monomers. These 3D articles are recyclable articles. By "recyclable" is meant articles, which can be dissolved, at least partly, when suitable dissolving solvents are used under suitable conditions.

In one embodiment, the 3D printed articles are obtained from multi-functional cyanoacrylate-based monomers. These 3D articles are durable articles (or solvent-resistant). By "durable" is meant articles, which cannot be dissolved in solvents.

The polymerised resin may comprise any additional compounds, such as fillers, pigments, plasticizers, etc.

The 3D printed articles may be of any shape, design and aesthetical aspect, considering the great versatility of the present 3D printing methods. In particular, the 3D printed articles are unstratified articles, even when manufactured from layer-by-layer 3D printing methods. In addition, the 3D articles are tack-free articles. By "tack-free" is meant that the article does not exhibit the so-called surface air inhibition, which is common in photoradical polymerization.

### Recycling method

In another aspect, the present invention relates to a method for recycling a 3D article made of polycyanoacrylate, obtained exclusively from mono-functional cyanoacrylate monomers, comprising the step of treating the 3D article with a dissolving solvent for a time sufficient for dissolving it.

This treatment step (recycling step) does not correspond to a postprocessing step (rinsing step).

The recycling step is carried out, when needed and desired, for example after the 3D article has served its purpose and is no longer needed.

The recycling step allows partial or complete dissolution of the 3D article, and the time should be chosen accordingly to the degree of dissolution expected. The recycling step may be carried out from 1 to 72 hours, preferably from 2 to 48 hours.

The recycling step may be carried out at ambient temperature or at an elevated temperature, in order to speed-up the dissolution of the 3D article. The temperature should, however, be less than the boiling temperature of the dissolving solvent.

When the 3D article (polyMECA) is exclusively obtained from 2-methoxyethyl cyanoacrylate monomers, preferable dissolving solvents for dissolving the 3D article include, but are not limited to, acetone, propylene carbonate, acetonitrile, isopropanol, toluene, ethyl acetate, tritolyl phosphate, glycerol triacetate, 2-methoxyethyl cyanoacetate.

When the 3D article (polyECA) is exclusively obtained from ethyl cyanoacrylate monomers, preferable dissolving solvents for dissolving the 3D article include, but are not limited to, acetone, propylene carbonate, acetonitrile, isopropanol, toluene, ethyl acetate, tritolyl phosphate, glycerol triacetate, ethyl cyanoacetate.

When the 3D article (polyMCA) is exclusively obtained from methyl cyanoacrylate monomers, preferable dissolving solvents for dissolving the 3D article include, but are not limited to, acetone, propylene carbonate, acetonitrile, isopropanol, toluene, ethyl acetate, tritolyl phosphate, glycerol triacetate, ethyl cyanoacetate, methyl cyanoacetate.

### EXAMPLES

### LIST OF MATERIALS

Different liquid resins have been used for printing 3D articles and different solvents have been used in the solvent treatment process.

The list of materials is the following:
Monomer 1: 2-methoxyethyl cyanoacrylate (MECA)
Monomer 2: methyl cyanoacrylate (MCA)
Monomer 3: polymethyl methacrylate
Monomer 4: 1,6-hexanediol bis-cyanoacrylate
Monomer 5: difunctional tricyclodecanedimethanol diacrylate
   Acidic inhibitor: BF₃Etherate (Lewis acid)
   Free radical stabilizer: Hydroquinone
      Photoinitiator 1: Ivocerin^{®} in 0.2 w/w% stock solution in 2-methoxyethyl cyanoacrylate
      Photoinitiator 2: Ivocerin^{®} as a pure solid
      Photoinitiator 3: Ferrocene in 2.5 w/w% stock solution in glyceroltriheptanoate (GTH)
   Thixotropic agent: hydrophobic fumed silica

### EXAMPLE 1

### Liquid resin: resin A (see table 1 below) with a viscosity of 39 cPs (room temperature, 50 rpm)

**Table 1**

| Resin A | Amounts |
|---|---|
| Monomer 1 (MECA) | 28.7 g |
| Acidic inhibitor | 5 ppm |
| Free radical stabilizer | 400 ppm |
| Photoinitiator 1 | 2.9 g |
| Photoinitiator 3 | 0.079 g |
| Thixotropic agent | 0.39 g |

Printing method: CAL method as described in the PCT application WO 2019/043529 A1 with a cylindrical tank having a diameter of about 18 mm.

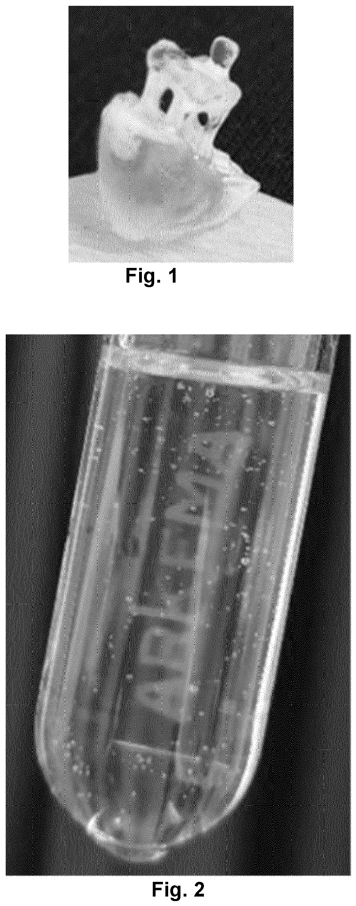

3D article shape: "3Dbenchy" calibration boat shape, as illustrated in Figure 1, which is a 3D computer-generated model, which has been specifically designed for testing the capabilities of 3D printing methods. This model has the shape of a small tugboat comprising various geometric arrangements, including rectangular and circular openings, overhangs of different inclination, slopes, solid and hollow box and cylindrical shapes, a blind hole and undercuts. It usual dimensions are 11 mm (length) x 7 mm (width) x 11 mm (height). It is usually considered as a benchmark 3D article (see the online publications https://3dprint.com/191141/3d-benchy-most-printed; https://3dprint.com/57361/3dbency-calibrating-tool/)

Lighting system: Laser diode operating at wavelengths 405 nm driven with a current of 600 mA.

Solvent treatment: After polymerization, the 3D article was removed from the liquid resin, before rinsing with a non-nucleophilic rinsing solvent. Typical rinsing operation includes: i) draining uncured resin from the vat using a cyanoacrylate-compatible filter (typical porous size of 1 mm) that also holds back the 3D article ii) immersing filter + printed article in a vessel containing a non-nucleophilic rinsing solvent and wait for 1 minute for any remaining liquid resin to be removed from the article iii) separating out the rinsed 3D article.

Additional light treatment: In addition, after carrying out the solvent treatment, the 3D article was exposed to an additional light source (blue LED, wavelength of 405 nm, light intensity of 50 mW/cm², time exposure of 30 sec).

The use of non-nucleophilic solvents was compared with the use of isopropanol (reference), as an example of nucleophilic solvents (see the results in table 2 below).

**Table 2**

| Trial | Print time | Solvent | Results |
|---|---|---|---|
| A1 | 9 | Acetone | Fragile - complete dissolution |
| A2 | 19 | Acetone | Fragile - complete dissolution |
| A3 | 19.4 | PGMEA | Modest integrity - partial dissolution |
| A4 | 25 | PGMEA | Good integrity and resolution |
| A5 | 25 | Perfluorooctane | Good integrity and resolution |
| A6 | 19 | Isopropanol (reference) | Instant polymerization of free monomers |

Isopropanol, which is an example of a nucleophilic solvent, is not a suitable solvent for carrying out the solvent treatment according to the present invention, as it initiates the polymerization of the free (unpolymerized) monomers present in the excess liquid resin.

### EXAMPLE 2

### Liquid resin: resin B (see table 3 below) with a viscosity of 52 cPs (room temperature, 50 rpm)

**Table 3**

| Resin B | Amounts |
|---|---|
| Monomer 1 (MECA) | 17.87 g |
| Acidic inhibitor | 5 ppm |
| Free radical stabilizer | 400 ppm |
| Photoinitiator 1 | 1.82 g |
| Photoinitiator 3 | 0.050 g |
| Thixotropic agent | 0.28 g |

Protocol: Same as in example 1, except that the light for selectively polymerizing the liquid resin was transmitted at a delivery dose of 60-70 %. In addition, after carrying out the solvent treatment, the 3D article was exposed to an additional light source (blue LED, wavelength of 405 nm, light intensity of 30 mW/cm², time exposure of 2 sec).

The implementation of a step of exposing the 3D to an additional source of light, after implementing the solvent treatment step, has been tested (see the results in table 4 below).

**Table 4**

| Trial | Print time | Solvent/light | Results |
|---|---|---|---|
| B1 | 15 | PGMEA/blue LED | Excellent integrity, resolution and dry-to-touch |

The implementation of a step of exposing the 3D to an additional source of light, after implementing the solvent treatment step, allows obtaining a 3D article with a satisfactory dry-to-touch surface.

### EXAMPLE 3

### Liquid resin: resin C (see table 5 below) with a viscosity of 40 cPs (room temperature, 50 rpm)

**Table 5**

| Resin C | Amounts |
|---|---|
| Monomer 2 (MCA) | 17.87 g |
| Acidic inhibitor | 5 ppm |
| Free radical stabilizer | 600 ppm |
| Photoinitiator 1 | 1.80 g |
| Photoinitiator 3 | 0.050 g |
| Thixotropic agent | 0.28 g |

Protocol: Same as in example 1, except that the light for selectively polymerizing the liquid resin was transmitted either at a delivery dose of 60-70 % (trial C1) or 40-50 % (trial C2).

It was compared a printing method comprising both a solvent treatment step and a step of exposing the 3D article to an additional light source *versus* none of both steps (reference) (see the results in table 6 below).

**Table 6**

| Trial | Print time | Solvent/light | Results |
|---|---|---|---|
| C1 | 6.3 | PGMEA/blue light | Good integrity and resolution |
| C2 | 7.4 | -/- | Limited integrity - Non-tacky |

### EXAMPLE 4

### Liquid resin: resin D (see table 7 below) with a viscosity of 38 cPs (room temperature, 50 rpm)

**Table 7**

| Resin D | Amounts |
|---|---|
| Monomer 2 (MCA) | 35.75 g |
| Acidic inhibitor | 10 ppm |
| Free radical stabilizer | 600 ppm |
| Photoinitiator 1 | 3.6 g |
| Photoinitiator 3 | 0.0925 g |
| Thixotropic agent | 0.55 g |

Protocol: Same as in example 1, except that the light for selectively polymerizing the liquid resin was transmitted at a delivery dose of 40-50 %.

It was compared a printing method comprising both a solvent treatment step and a step of exposing the 3D to an additional light source *versus* none of both steps (reference) (see the results in table 8 below).

**Table 8**

| Trial | Print time | Solvent/light | Results |
|---|---|---|---|
| D1 | 26 | -/- | Good integrity and resolution Slight over-exposition |
| D2 | 21 | -/- | Good integrity and resolution |
| D3 | 14 | PGMEA/blue light | Very good integrity and resolution |
| D4 | 12 | PGMEA/blue light | Very good integrity and resolution |
| D5 | 10 | -/- | Limited integrity (fragile) |

### EXAMPLE 5

### Liquid resin: resin E (see table 9 below) with a viscosity of 58 cPs (room temperature, 50 rpm)

**Table 9**

| Resin E | Amounts |
|---|---|
| Monomer 2 (MCA) | 35.75 g |
| Acidic inhibitor | 10 ppm |
| Free radical stabilizer | 600 ppm |
| Photoinitiator 1 | 3.6 g |
| Photoinitiator 3 | 0.100 g |
| Thixotropic agent | 0.63 g |

Protocol: Same as in example 1, except that the light for selectively polymerizing the liquid resin was transmitted at a delivery dose of 50 %.

The printing device was set-up for printing a 3D article onto which the logo "ARKEMA" was printed, instead of the "3Dbenchy" boat shape (see the results in table 10 below). The 3D logo obtained with the ARKEMA logo is shown in Figure 2 and has the following dimensions: 22 mm (length) x 6 mm (width) x 3 mm (height).

Rinsing operations vary in some of the following examples: in E1 and E2 the 3D article was exposed to the non-nucleophilic rinsing solvent for one minute whereas in E3 and E4 the article was simply dipped in said solvent for approximately 5 seconds.

'Excessive polymerization' refers to polymerization beyond the aimed volume to be printed.

**Table 10**

| Trial | Print time | Solvent/light | Results |
|---|---|---|---|
| E1 | 20 | PGMEA/blue light | Good resolution, but logo with a small size - slight whitening |
| E2 | 20 | PGMEA/- | Poor resolution, but logo with a bigger size - slight whitening |
| E3 | 16 | PGMEA dip/blue light | Slight excessive polymerization Good resolution No whitening after light exposure |
| E4 | 13 | PGMEA dip/blue light | Very good resolution - no whitening |

### EXAMPLE 6

### Liquid resin: resin H (see table 11 below) with a viscosity of 39 cPs (room temperature, 50 rpm)

**Table 11**

| Resin H | Amounts |
|---|---|
| Monomer 1 | 28.4 g |
| Monomer 4 | 0.3 g |
| Inhibitor (ppm) | 15 ppm |
| Stabilizer (ppm) | 400 ppm |
| Photoinitiator 1 | 2.9 g |
| Photoinitiator 3 | 0.079 g |
| Thixotropic agent | 0.39 g |

The results are shown in table 12 below.

Testing for insolubility of the 3D article in solvents is measured on bulk cured polymers (0.3 g) after immersing samples for 24 hours in acetone (20 mL). The insoluble part is filtered and dried at 60 °C to constant mass and compared to the original mass or the cured material. As virtue of example polymers obtained in example 1-9 are fully soluble.

**Table 12**

| Trial | Print time | Solvent/light | Results |
|---|---|---|---|
| H1 | 40 | Acetonitrile/- | Modest integrity with partial collapse |
| H2 | 60 | Acetonitrile/- | Good integrity and resolution Insolubility of the 3D article in the solvent |

### EXAMPLE 7

### Liquid resins: resins I to L (see table 13 below) with respective viscosities of 6 cPs, 200 cPs, 10 cPs and 33 cPs (room temperature, 50 rpm)

**Table 13**

| Resin | I | J | K | L |
|---|---|---|---|---|
| Monomer 1 | q.s. 100 | q.s. 100 | q.s. 100 | q.s. 100 |
| Monomer 3 | - | 5.6% | - | - |
| Monomer 4 | - | - | 5% | - |
| Monomer 5 | - | - | - | 20% |
| Acidic inhibitor | 70ppm | 70ppm | 70ppm | 70ppm |
| Photoinitiator 2 | 0.075% | 0.075% | 0.075% | 0.075% |
| Photoinitiator 3 | 0.02% | 0.02% | 0.02% | 0.02% |

Printing method: CLIP method.

### 3D article shape: Oblong or cylindrical shape

Lighting system: 100 LEDs (wavelength of 450 nm, irradiance of about 3 mW/cm², initial light exposure for the base layer of 60 sec, continuous light exposure for the main body of 3,000 sec).
LCD mask: yes
Platform elevation: Continuous rate of 100 µm per 60 sec
Solvent treatment: After polymerization, the 3D article was removed from the platform, before being rinsed with a non-nucleophilic rinsing solvent.

Additional light treatment: After the solvent treatment step, the 3D articles are exposed 10 seconds to a low-powdered blue LED torch (wavelength of 405 nm).

The results are shown in table 14 below.

**Table 14**

| Trial | Solvent/light | Results |
|---|---|---|
| I1 | Acetic acid/blue LED | Excellent integrity and resolution |
| I2 | PGMEA/blue LED | Excellent integrity and resolution |
| I3 | Perfluorooctane/blue LED | Excellent integrity and resolution |
| I4 | Isopropanol (reference)/blue LED | Total polymerization while rinsing |
| J1 | PGMEA/blue LED | Excellent integrity and resolution |
| K1 | PGMEA/blue LED | Excellent integrity and resolution Insolubility of the 3D article in the solvent |
| L1 | PGMEA/blue LED | Excellent integrity and resolution Insolubility of the 3D article in the solvent |

## Claims

1. A method for printing a three-dimensional (3D) article, comprising the steps of:
a) providing a volume of liquid resin comprising cyanoacrylate-based monomers, a photoinitiator system promoting anionic or zwitterionic photopolymerization and an acidic inhibitor, held in a tank, said tank comprising at least one optically transparent portion;
b) defining a polymerization zone;
c) emitting and controlling light and transmitting it to the liquid resin through the optically transparent portion for selectively polymerizing the liquid resin in the polymerization zone; and
d) obtaining a three-dimensional article made of a polymerized resin;
e) treating the obtained three-dimensional article with a non-nucleophilic rinsing solvent for removing the excess liquid resin; and,
f) optionally exposing the obtained three-dimensional article with an additional light source for rendering the article non tacky.

2. A printing method according to claim 1, in which the cyanoacrylate-based monomers are selected from the group consisting of mono-functional cyanoacrylate monomers, multi-functional cyanoacrylate monomers including bifunctional cyanoacrylate monomers, hybrid cyanoacrylate monomers, and mixtures thereof.

3. A printing method according to any preceding claims, in which the cyanoacrylate-based monomers are exclusively mono-functional cyanoacrylate monomers; or alternatively in which the cyanoacrylate-based monomers are multi-functional cyanoacrylate monomers, hybrid cyanoacrylate monomers or mixtures thereof and optionally mono-functional cyanoacrylate monomers.

4. A printing method according to any one of the preceding claims, in which the cyanoacrylate-based monomers are selected from 2-methoxyethyl cyanoacrylate, methyl cyanoacrylate, ethyl cyanoacrylate, n-propyl cyanoacrylate, iso-propyl cyanoacrylate or mixtures thereof; preferably from 2-methoxyethyl cyanoacrylate, methyl cyanoacrylate or mixtures thereof.

5. A printing method according to any one of the preceding claims, in which the liquid resin comprises additional photopolymerizable monomers, preferably (meth)acrylate monomers.

6. A printing method according to any one of the preceding claims, in which the non-nucleophilic solvent is selected from the group consisting of non-basic solvents, non-ionic solvents (or solutions) and mixtures thereof.

7. A printing method according to any one of the preceding claims, in which the non-nucleophilic rinsing solvent is selected from the group consisting of hydrocarbon and perfluorinated hydrocarbon solvents, ether solvents, acetate solvents, chlorohydrocarbon solvents, polar aprotic solvents, and mixtures thereof.

8. A printing method according to any one of the preceding claims, in which the step of treating the three-dimensional article with a non-nucleophilic rinsing solvent is carried out during a period of 10 minutes or less, preferably of 4 minutes or less, more preferably of 3 minutes or less.

9. A printing method according to any one of the preceding claims, in which the step of treating the three-dimensional article with a non-nucleophilic rinsing solvent is carried out by dipping the three-dimensional article into the non-nucleophilic solvent for a period of 15 seconds or less.

10. A printing method according to any one of the preceding claims, in which the step of exposing the three-dimensional article to an additional light source is carried out at a wavelength from 380 nm to 470 nm.

11. A printing method according to any one of the preceding claims, in which the step of exposing the three-dimensional article to an additional light source is carried out for a period of 60 seconds or less, preferably from 1 to 30 seconds, more preferably from 1 to 20 seconds.

12. A printing method according to any one of the preceding claims, in which the photoinitiator system comprises a metallocene component; preferably the metallocene compound is selected from the group consisting of ferrocene compounds, ruthenocene compounds, bis(cyclopentadieneyl) osmium compounds, their derivatives thereof, and mixtures thereof; more preferably the metallocene compound is a ferrocene compound, its derivatives thereof, and mixtures thereof.

13. A printing method according to claim 12, in which the photoinitiator system also comprises an additional photoinitiator; preferably the additional photoinitiator is selected from the group consisting of phenyl-substituted acyl phosphines, alpha diketones, thioxanthones, alpha-hydroxy ketones, benzyldimethylketals, phenylglyoxylates, camphorquinone, acylgermane compounds, dialkylsilylglyoxylates, and mixtures thereof.

## Patentansprüche

1. Verfahren zum Drucken eines dreidimensionalen (3D) Gegenstands, umfassend die folgenden Schritte:
a) Bereitstellen eines Volumens eines flüssigen Harzes, umfassend Monomere auf Cyanacrylatbasis, ein Photoinitiatorsystem, das anionische oder zwitterionische Photopolymerisation fördert, und einen sauren Inhibitor, die in einem Tank enthalten sind, wobei der Tank mindestens einen optisch transparenten Abschnitt umfasst;
b) Definieren einer Polymerisationszone;
c) Emittieren und Steuern von Licht und dessen Übertragen auf das flüssige Harz durch den optisch transparenten Abschnitt zum selektiven Polymerisieren des flüssigen Harzes in der Polymerisationszone; und
d) Erlangen eines dreidimensionalen Gegenstands, der aus einem polymerisierten Harz gefertigt ist;
e) Behandeln des erlangten dreidimensionalen Gegenstands mit einem nichtnukleophilen Spüllösungsmittel zum Entfernen des überschüssigen flüssigen Harzes; und,
f) optionales Belichten des erlangten dreidimensionalen Gegenstands mit einer zusätzlichen Lichtquelle, um den Gegenstand nicht klebrig zu machen.

2. Druckverfahren nach Anspruch 1, wobei die Monomere auf Cyanacrylatbasis ausgewählt sind aus der Gruppe, bestehend aus monofunktionellen Cyanacrylatmonomeren, multifunktionellen Cyanacrylatmonomeren einschließlich bifunktionellen Cyanacrylatmonomeren, Hybridcyanacrylatmonomeren und Gemischen davon.

3. Druckverfahren nach einem der vorherigen Ansprüche, wobei die Monomere auf Cyanacrylatbasis ausschließlich monofunktionelle Cyanacrylatmonomere sind; oder alternativ, wobei die Monomere auf Cyanacrylatbasis multifunktionelle Cyanacrylatmonomere, hybride Cyanacrylatmonomere oder Gemische davon und optional monofunktionelle Cyanacrylatmonomere sind.

4. Druckverfahren nach einem der vorherigen Ansprüche, wobei die Monomere auf Cyanacrylatbasis ausgewählt sind aus 2-Methoxyethylcyanacrylat, Methylcyanacrylat, Ethylcyanacrylat, n-Propylcyanacrylat, Isopropylcyanacrylat oder Gemischen davon; vorzugsweise aus 2-Methoxyethylcyanacrylat, Methylcyanacrylat oder Gemischen davon.

5. Druckverfahren nach einem der vorherigen Ansprüche, wobei das flüssige Harz zusätzliche photopolymerisierbare Monomere umfasst, vorzugsweise (Meth)acrylatmonomere.

6. Druckverfahren nach einem der vorherigen Ansprüche, wobei das nicht-nukleophile Lösungsmittel ausgewählt ist aus der Gruppe, bestehend aus nichtbasischen Lösungsmitteln, nicht-ionischen Lösungsmitteln (oder Lösungen) und Gemischen davon.

7. Druckverfahren nach einem der vorherigen Ansprüche, wobei das nicht-nukleophile Spüllösungsmittel ausgewählt ist aus der Gruppe, bestehend aus Kohlenwasserstoff- und perfluorierten Kohlenwasserstofflösungsmitteln, Etherlösungsmitteln, Acetatlösungsmitteln, Chlorkohlenwasserstofflösungsmitteln, polaren aprotischen Lösungsmitteln und Gemischen davon.

8. Druckverfahren nach einem der vorherigen Ansprüche, wobei der Schritt eines Behandelns des dreidimensionalen Gegenstands mit einem nichtnukleophilen Spüllösungsmittel während eines Zeitraums von 10 Minuten oder weniger, vorzugsweise von 4 Minuten oder weniger, bevorzugter von 3 Minuten oder weniger, durchgeführt wird.

9. Druckverfahren nach einem der vorherigen Ansprüche, wobei der Schritt eines Behandelns des dreidimensionalen Gegenstands mit einem nichtnukleophilen Spüllösungsmittel durch Eintauchen des dreidimensionalen Gegenstands in das nicht-nukleophile Lösungsmittel über einen Zeitraum von 15 Sekunden oder weniger durchgeführt wird.

10. Druckverfahren nach einem der vorherigen Ansprüche, wobei der Schritt eines Belichtens des dreidimensionalen Gegenstands mit einer zusätzlichen Lichtquelle bei einer Wellenlänge von 380 nm bis 470 nm durchgeführt wird.

11. Druckverfahren nach einem der vorherigen Ansprüche, wobei der Schritt eines Belichtens des dreidimensionalen Gegenstands mit einer zusätzlichen Lichtquelle über einen Zeitraum von 60 Sekunden oder weniger, vorzugsweise von 1 bis 30 Sekunden, bevorzugter von 1 bis 20 Sekunden, durchgeführt wird.

12. Druckverfahren nach einem der vorherigen Ansprüche, wobei das Photoinitiatorsystem eine Metallocenkomponente umfasst; die Metallocenverbindung vorzugsweise ausgewählt ist aus der Gruppe, bestehend aus Ferrocenverbindungen, Ruthenocenverbindungen, bis(Cyclopentadienyl)osmiumverbindungen, deren Derivaten und Gemischen davon; die Metallocenverbindung bevorzugter eine Ferrocenverbindung, deren Derivate und Gemische davon ist.

13. Druckverfahren nach Anspruch 12, wobei das Photoinitiatorsystem auch einen zusätzlichen Photoinitiator umfasst; vorzugsweise der zusätzliche Photoinitiator ausgewählt ist aus der Gruppe, bestehend aus phenylsubstituierten Acylphosphinen, alpha-Diketonen, Thioxanthonen, alpha-Hydroxyketonen, Benzyldimethylketalen, Phenylglyoxylaten, Campherchinon, Acylgermanverbindungen, Dialkylsilylglyoxylaten und Gemischen davon.

## Revendications

1. Procédé d'impression d'un article tridimensionnel (3D), comprenant les étapes de :
a) fourniture d'un volume de résine liquide comprenant des monomères à base de cyanoacrylate, un système de photoamorceur favorisant la photopolymérisation anionique ou zwitterionique et un inhibiteur acide, contenu dans un réservoir, ledit réservoir comprenant au moins une partie optiquement transparente ;
b) définition d'une zone de polymérisation ;
c) émission et commande de lumière et transmission de celui-ci à la résine liquide à travers la partie optiquement transparente pour polymériser sélectivement la résine liquide dans la zone de polymérisation ; et
d) obtention d'un article tridimensionnel constitué d'une résine polymérisée ;
e) traitement de l'article tridimensionnel obtenu avec un solvant de rinçage non nucléophile pour éliminer l'excès de résine liquide ; et,
f) éventuellement exposition de l'article tridimensionnel obtenu avec une source de lumière supplémentaire pour rendre l'article non collant.

2. Procédé d'impression selon la revendication 1, dans lequel les monomères à base de cyanoacrylate sont choisis dans le groupe constitué de monomères de cyanoacrylate monofonctionnels, monomères de cyanoacrylate multifonctionnels comprenant des monomères de cyanoacrylate bifonctionnels, des monomères de cyanoacrylate hybrides et leurs mélanges.

3. Procédé d'impression selon l'une quelconque des revendications précédentes, dans lequel les monomères à base de cyanoacrylate sont exclusivement des monomères de cyanoacrylate monofonctionnels ; ou alternativement dans lequel les monomères à base de cyanoacrylate sont des monomères de cyanoacrylate multifonctionnels, des monomères de cyanoacrylate hybrides ou des mélanges de ceux-ci et optionnellement des monomères de cyanoacrylate monofonctionnels.

4. Procédé d'impression selon l'une quelconque des revendications précédentes, dans lequel les monomères à base de cyanoacrylate sont choisis parmi le cyanoacrylate de 2-méthoxyéthyle, le cyanoacrylate de méthyle, le cyanoacrylate d'éthyle, le cyanoacrylate de n-propyle, le cyanoacrylate d'isopropyle ou leurs mélanges ; préférentiellement parmi le cyanoacrylate de 2-méthoxyéthyle, le cyanoacrylate de méthyle ou leurs mélanges.

5. Procédé d'impression selon l'une quelconque des revendications précédentes, dans lequel la résine liquide comprend des monomères photopolymérisables supplémentaires, préférentiellement des monomères de (méth)acrylate.

6. Procédé d'impression selon l'une quelconque des revendications précédentes, dans lequel le solvant non nucléophile est choisi dans le groupe constitué de solvants non basiques, de solvants (ou solutions) non ioniques et leurs mélanges.

7. Procédé d'impression selon l'une quelconque des revendications précédentes, dans lequel le solvant de rinçage non nucléophile est choisi dans le groupe constitué de solvants hydrocarbures et hydrocarbures perfluorés, solvants éthers, solvants acétates, solvants chlorohydrocarbures, solvants aprotiques polaires, et leurs mélanges.

8. Procédé d'impression selon l'une quelconque des revendications précédentes, dans lequel l'étape de traitement de l'article tridimensionnel avec un solvant de rinçage non nucléophile est réalisée pendant une durée de 10 minutes ou moins, préférentiellement de 4 minutes ou moins, plus préférentiellement de 3 minutes ou moins.

9. Procédé d'impression selon l'une quelconque des revendications précédentes, dans lequel l'étape de traitement de l'article tridimensionnel avec un solvant de rinçage non nucléophile est réalisée par immersion de l'article tridimensionnel dans le solvant non nucléophile pendant une durée de 15 secondes ou moins.

10. Procédé d'impression selon l'une quelconque des revendications précédentes, dans lequel l'étape d'exposition de l'article tridimensionnel à une source de lumière supplémentaire est réalisée à une longueur d'onde de 380 nm à 470 nm.

11. Procédé d'impression selon l'une quelconque des revendications précédentes, dans lequel l'étape d'exposition de l'article tridimensionnel à une source de lumière supplémentaire est réalisée pendant une durée de 60 secondes ou moins, préférentiellement de 1 à 30 secondes, plus préférentiellement de 1 à 20 secondes.

12. Procédé d'impression selon l'une quelconque des revendications précédentes, dans lequel le système de photoamorceur comprend un composant métallocène ; préférentiellement le composé métallocène est choisi dans le groupe constitué de composés ferrocènes, composés ruthénocènes, composés de bis(cyclopentadiényl)osmium, leurs dérivés et leurs mélanges ; plus préférentiellement le composé métallocène est un composé ferrocène, ses dérivés et ses mélanges.

13. Procédé d'impression selon la revendication 12, dans lequel le système photoamorceur comprend également un photoamorceur supplémentaire ; préférentiellement le photoamorceur supplémentaire est choisi dans le groupe constitué d'acylphosphines substituées par phényle, alpha-dicétones, thioxanthones, alpha-hydroxycétones, benzyldiméthylcétals, phénylglyoxylates, camphorquinone, composés acylgermanes, dialkylsilylglyoxylates et leurs mélanges.
